# EUROPEAN PATENT APPLICATION

(11) **EP 1 852 743 A1**
(43) Date of publication of application: **07.11.2007**
(21) Application number: 07008675.6
(22) Date of filing: 27.04.2007
(51) Int. Cl.: G03F 7/023

(54) **Method for manufacturing photosensitive resin composition and relief pattern using the same**

(30) Priority: 01.05.2006 JP 2006127728
(71) Applicant: FUJIFILM Corporation, Minato-ku Tokyo (JP)
(72) Inventor: Yamanaka, Tsukasa, Haibara-gun Shizuoka (JP)
(74) Representative: HOFFMANN EITLE

(57) **Abstract**

A method for manufacturing a positive photosensitive resin composition, the method comprising: filtering a composition having a concentration of solids content of 30 mass% or more through a hollow fiber filter having a pore size of 0.1 µm or less, wherein the composition comprises: (A) resin; (B) a photosensitizer; and (C) a solvent, and a relief pattern formed with the photosensitive resin composition.

## Description

### Background of the Invention

### 1. Field of the Invention

The present invention relates to a photosensitive resin composition, more specifically relates to a photosensitive resin composition suitable for application to the field of microelectronics and capable of development with an alkali aqueous solution, a manufacturing method of the composition, and a manufacturing method of a semiconductor device using the composition.

### 2. Description of the Related Art

Urgent demands are increased for a photosensitive resin composition of a thick film for various uses, e.g., higher integration of circuit, development of micro-machine, surface protective films of various electronic parts such as semiconductor, layer insulation films, and buffer coat films. In any of these uses, particles in the photosensitive resin composition are preferably small in number for the uniformity of film quality, improvement of coating property, and prevention of light scattering in a film. In particular, when the number of particles having a size of about 0.5 µm or more is 1, 000/ml or less, scattering loss decreases and influences of light scattering by particles can be improved.

The reduction of content of particles in a photosensitive composition can be achieved by many times of filtration with a small pore size filter. JP-A-5-186592 (the term "JP-A" as used herein refers to an "unexamined published Japanese patent application") discloses to perform filtration just after mixture and dissolution of a resin monomer and then progress polymerization. Regarding the pore size of the filter at that time, it is well known to use the least pore size of 0.2 µm or so available at present. However, since there is generally a rule of logarithmic reverse proportion between the quantity of flow by filtration of solution processed through a filter and the viscosity thereof, filtering process of a highly viscous photosensitive composition of 30 poises or more takes a lot of time, and viscosity fluctuation progresses during the filtration process, so that manufacturing problems arise. Therefore, a highly viscous composition is generally unavoidable to be filtered through a filter having a pore size of 0.3 µm or more, so that the content of particles of 0.5 µm or more becomes 1, 000/ml or more and the application to the materials of electronic parts and optics cannot be said to be sufficient.

For solving these problems, a method of synthesizing resin with a solvent and the monomer component of the resin having been filtered through a filter having a pore size of 0.2 µm or less in advance, and further performing filtration process with a membrane filter having a pore size of 0.2 µm or less is disclosed in JP-A-5-186592. However, this method is not practicable, since filtration takes long hours in the case of a highly viscous photosensitive composition of 30 poises or more in final filtration process and fluctuation of viscosity occurs as described above. There is also disclosed in JP-A-5-186592 a method to remove particles by filtration process through a membrane filter having a pore size of 0.2 µm or less in the state of solution viscosity of resin of 30 poises or less when the solution viscosity increase by polymerization reaction of the monomer component of the resin is gentle. However, when synthesis is on a large scale, this method is hardly practicable, since there are cases where the viscosity increases to 30 poises or more during filtration if long hours are taken, and filtration becomes impossible. JP-A-7-292106 discloses a method capable of reducing particles according to the manufacturing method of a composition. However, this method cannot be applied to every photosensitive resin composition and manufacturing aptitude is also insufficient.

As photosensitive compositions suitable to the invention, chemical amplification positive resists for a thick film disclosed in JP-A-2004-309777, chemical amplification negative resists for a thick film disclosed in JP-A-2003-114531, super heat resisting positive photosensitive compositions disclosed in U.S. Patent 4,371,685, and negative photosensitive compositions disclosed in JP-A-2000-284480 can be exemplified.

U.S. Patent 4,371,685 discloses a positive photosensitive composition containing an alkali- soluble PBO precursor and a diazoquinone photoactive compound.

The diazoquinone compound prevents the PBO precursor from dissolving in an aqueous base, and after exposure converts to indenecarboxylic acid by photolysis to accelerate dissolution of the PBO precursor in an alkali developing solution.

### Summary of the Invention

An object of the invention is to provide a method for manufacturing a photosensitive resin composition capable of manufacturing a relief structure excellent in manufacturing aptitude and having a heat resisting property, and conspicuously reduced in generation of coating defects, and another object is to provide a manufacturing method of a semiconductor device with the photosensitive resin composition manufactured by the method.
(1) A method for manufacturing a positive photosensitive resin composition, the method comprising:
   filtering a composition having a concentration of solids content of 30 mass% or more through a hollow fiber filter having a pore size of 0.1 µm or less, wherein the composition comprises: (A) resin; (B) a photosensitizer; and (C) a solvent.
(2) The method as described in (1) above,
   wherein the resin (A) is a resin containing at least one structure selected from the group consisting of a polyimide structure, a polyimide precursor structure, a polybenzoxazole structure and a polybenzoxazole precursor structure.
(3) The method as described in (1) or (2) above, which further comprises:
   filtering a resin solution comprising a solvent in which the resin (A) is dissolved through a filter having a pore size of 0.2 µm or less before filtering the composition.
(4) The method as described in any of (1) to (3) above,
   wherein the resin (A) is a polyamide resin containing a naphthoquinonediazide group.
(5) The method as described in any of (1) to (3) above,
   wherein the resin (A) is a polyamide resin containing an acid decomposable group.
(6) The method as described in any of (1) to (5) above,
   wherein the photosensitizer (B) is selected from the group consisting of a naphthoquinonediazide photosensitizer and a photo-acid generator.
(7) A relief pattern obtained by a process comprising:
   applying a photosensitive resin composition manufactured by a method as described in any of (1) to (6) above on a substrate, so as to form a film;
   baking the film, so as to form a dried film;
   exposing the dried film with actinic ray or radiation, so as to form an exposed film; and
   developing the exposed film with a developing solution, so as to form a relief pattern.
(8) The relief pattern as described in (7) above,
   wherein the process further comprises:
   heating the exposed film before developing the exposed film.
(9) The relief pattern as described in (7) or (8) above, which is subjected to a heat processing at 200 to 400°C.
(10) The method as described in any of (1) to (6) above,
   wherein a material of the hollow fiber filter is at least one selected from the group consisting of polyacrylonitrile, polypropylene, polyethylene, nylon, plyester, polycarbonate, polyvinylidene fluoride and ethylene-tetrafluoroethylene.

### Brief Description of the Drawing

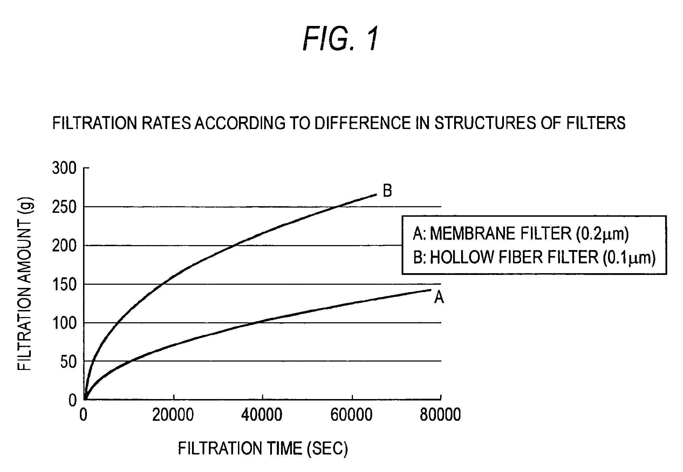

Fig. 1 is a graph showing the filtration rate by each filter.

### Detailed Description of the Invention

The method for manufacturing a positive photosensitive composition in the invention comprises filtering a positive photosensitive resin composition having a concentration of solids content of 30 mass% or more through a hollow fiber filter having a pore size of 0.1 µm or less, in which the positive photosensitive resin composition contains (A) resin, (B) a photosensitizer, and (C) a solvent. (In this specification, mass ratio is equal to weight ratio.)

### [1] Hollow Fiber Filter

The materials of hollow fiber membrane of hollow fiber filter for use in the method of the invention include polyolefin, such as polysulfone, polyacrylonitrile, polypropylene, polyethylene, poly(4-methylpentene-1), etc., nylon, plyester, polycarbonate, polyvinylidene fluoride, ethylene- tetrafluoroethylene copolymer, etc., are exemplified, and especially preferably polyacrylonitrile, polypropylene, polyethylene, nylon, plyester, polycarbonate, polyvinylidene fluoride, and ethylene-tetrafluoroethylene are exemplified.

The pore size of a hollow fiber filter is 0.1 µm or less, and especially preferably from 0.01 to 0.1 µm. That is, 0.1 µm or less is preferred in the point of capture of particles, and 0.01 µm or more is preferred in the point of filtering rate.

Manufacturing methods of hollow fiber membranes for use in hollow fiber filters are disclosed in Japanese Patent Nos. 25274070, 2533787, 2550543, 2553248, 2572895, 2592725 and 2622629. The manufacturing methods of filter cartridges using the hollow fiber membranes are disclosed in Japanese Patent Nos. 3641661 and 3641332.

The pressure of pressure filtration is not especially restricted so long as a hollow fiber membrane and filter housing do not break and necessary and sufficient quantity of filtration can be secured. The pressure is preferably from 0.05 to 1.0 MPa, and especially preferably from 0.1 to 0.7 MPa. The kinds of gases for use in pressuring are preferably air, oxygen, nitrogen, inert gases (He, Ne, Ar, Kr), etc. Nitrogen and inert gases are preferred of these gases in the point of oxidation prevention of photosensitive materials.

The temperature of compositions in filtration is preferably from 0 to 60°C, and more preferably from 10 to 40°C.

It is preferred to appropriately remove air in filling a solution in a filter for securing filtering rate and quantity of filtration. Further, the work of making the solution and the filter conformable by weak pressure after removal of air is very effective in securing filtering rate and quantity of filtration.

The viscosity of composition having the concentration of solids content of 30 mass% is preferably 0.5 Pa·s or more, and more preferably 1.0 Pa·s or more to 3.0 Pa·s or less.

### [2] Resin

Resin (A) contained in the positive photosensitive resin composition in the invention is resin containing, e.g., a polybenzoxazole precursor structure, a polybenzoxazole structure, a polyimide structure, a polyimide precursor structure, or polyamidic ester structure. In connection to these resins, resins having a hydroxyl group, a carboxyl group or a sulfonic acid group on the main chain or side chain are particularly exemplified.

Resin (A) is preferably resin containing at least one structure selected from the group consisting of a polyimide structure, a polyimide precursor structure, a polybenzoxazole structure, and a polybenzoxazole precursor structure.

Polyamide resins containing a naphthoquinonediazide group and/or an acid decomposable group are also preferred.

It is preferred to prepare a photosensitive resin composition by using a solution obtained by filtering a resin solution comprising a solvent in which resin is dissolved, such as a reaction solution after synthesis of resin, or a solution comprising a solvent in which resin is newly dissolved, through a filter having a pore size of 0.2 µm or less.

The filter having a pore size of 0.2 µm means that capture efficiency of polystyrene latex particles having a particle size of 0.2 µm or more is 99.999% or more by filtering with the filer.

Polyamide resin containing a structure represented by the following formula (2) is preferred.

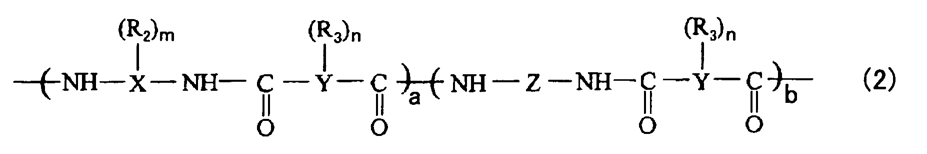

In formula (2), X represents any of a divalent to tetravalent organic group; Y represents any of a divalent to hexavalent organic group; R₂ represents a hydroxyl group, a carboxyl group, or -O-R₄; m represents an integer of from 0 to 2; R₃ represents a hydroxyl group, a carboxyl group, -O-R₄ or -COO-R₄; n represents an integer of from 0 to 4; when a plurality of R₂ and R₃ are present, they may be the same or different; R₄ represents an organic group having from 1 to 15 carbon atoms; and Z represents a group represented by the following formula. 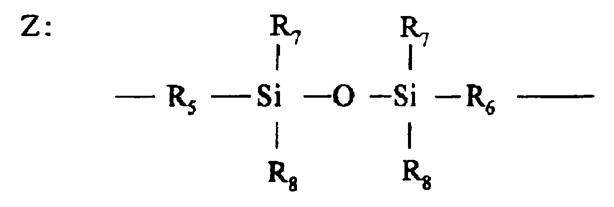 wherein R₅ and R₆ each independently represents a divalent organic group; R₇ and R₈ each independently represents a monovalent organic group; a is from 60 to 100 mol%, b is from 0 to 40 mol%, and a+b is 100 mol%.

Polyamide resin containing the structure represented by formula (2) comprises, e.g., diamine, dicarboxylic acid, and an acid anhydride.

X in polyamide resin containing the structure represented by formula (2) represents any of a divalent to tetravalent organic group, R₂ represents a hydroxyl group or -O-R₄, and m represents an integer of from 0 to 2, which may be the same or different.

Y represents any of a divalent to hexavalent organic group, R₃ represents a hydroxyl group, a carboxyl group, -O-R₄ or -COO-R₄, n represents an integer of from 0 to 4, which may be the same or different, and R₄ represents an organic group having from 1 to 15 carbon atoms.

However, at least any one of R₂ and R₃ represents at least either a hydroxyl group or a carboxyl group.

As described later in PBO precursor (F), the hydroxyl group as R₂ may be protected with a quinonediazide group.

The polyamide resin containing the structure represented by formula (2) is a resin obtained by the reaction of a compound selected from diamine or bis(aminophenol), 2,4-diaminophenol, etc., having the structure of X, silicone diamine having the structure of Z that is blended according to necessity, and a compound selected from tetracarboxylic anhydride, trimellitic anhydride, dicarboxylic acid, dicarboxylic acid dichloride, dicarboxylic acid derivative, hydroxydicarboxylic acid, hydroxydicarboxylic acid derivative, etc., having the structure of Y. Incidentally, in the case of dicarboxylic acid, active ester type dicarboxylic acid derivative previously subjected to reaction with 1-hydroxy-1,2,3-benzotriazole, etc., may be used for increasing the reaction yield.

In the polyamide resin containing the structure represented by formula (2), -O-R₄ as the substituent of X, and -O-R₄ and -COO-R₄ as the substituent of Y are groups protected with an organic group having from 1 to 15 carbon atoms for the purpose of adjusting the solubility of the hydroxyl group and carboxyl group in an alkali aqueous solution, and if necessary, the hydroxyl group and carboxyl group may be protected. As the examples of R₄, a formyl group, a methyl group, an ethyl group, a propyl group, an isopropyl group, a t-butyl group, a t-butoxycarbonyl group, a phenyl group, a benzyl group, a tetrahydrofuranyl group, a tetrahydropyranyl group, etc., are exemplified.

By heating the polyamide resin at 300 to 400°C, dehydration ring closure occurs and heat resistive resin is obtained in the form of polyimide or polybenzoxazole or the copolymer of both.

As X in formula (2), for example, the following groups can be exemplified, and two or more groups may be used.

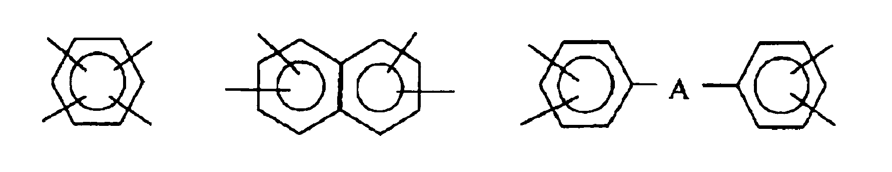

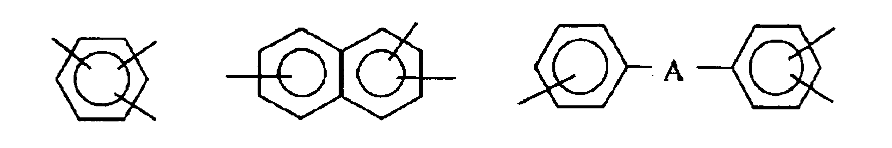

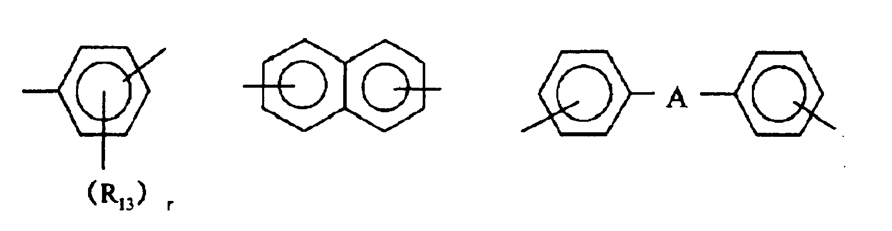

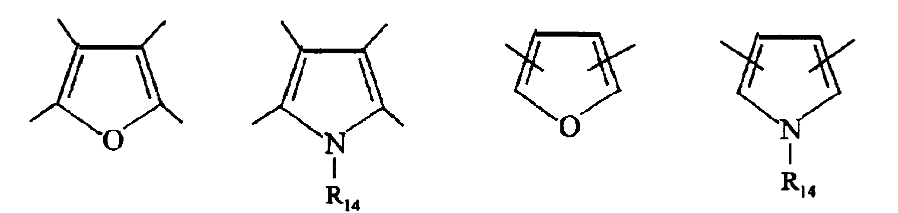

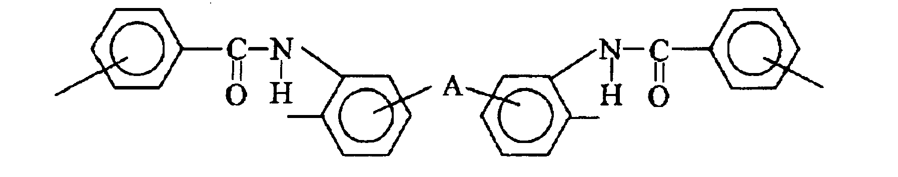

In the above formulae, A represents -CH₂-, -C(CH₃)₂-, -O-, -S-, -SO₂- -CO-, -NHCO-, -C(CF₃)₂-, or a single bond.

R₁₃ represents an alkyl group, an alkyl ester group, or a halogen atom. r represents an integer of from 0 to 2. A plurality of R₁₃'s may be the same or different.

R₁₄ represents a hydrogen atom, an alkyl group, an alkyl ester group, or a halogen atom.

As particularly preferred of these, the following groups can be exemplified.

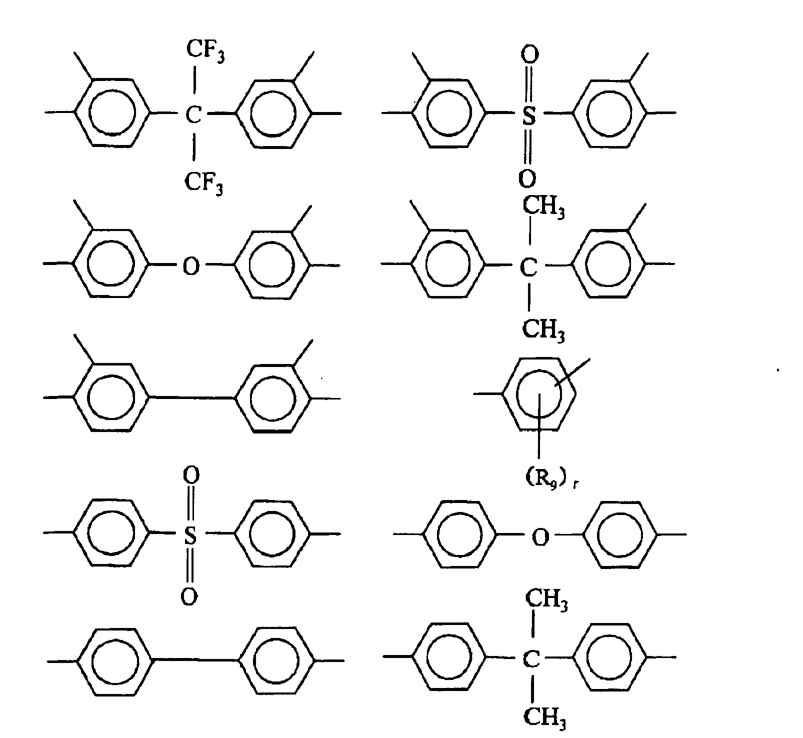

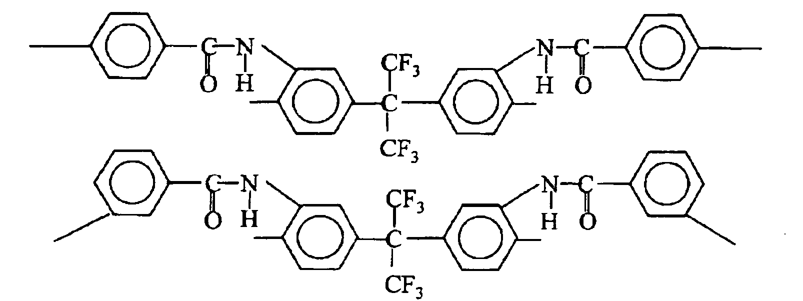

In the above, R₉ represents an alkyl group, an alkyl ester group, or a halogen atom. r represents an integer of from 0 to 2. A plurality of R₉'s may be the same or different.

In formula (2), the following groups can be exemplified as Y, and two or more groups may be used.

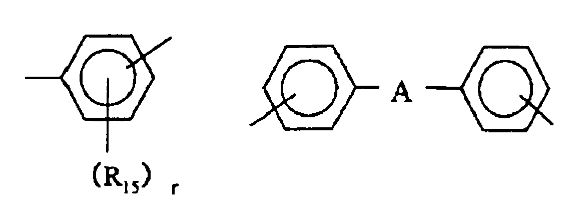

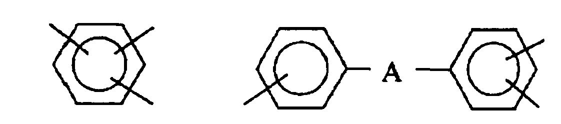

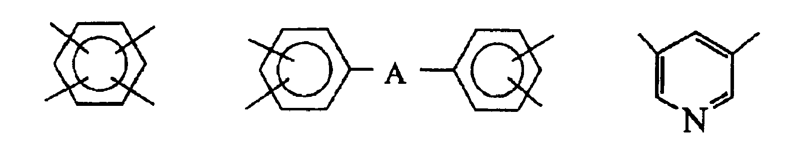

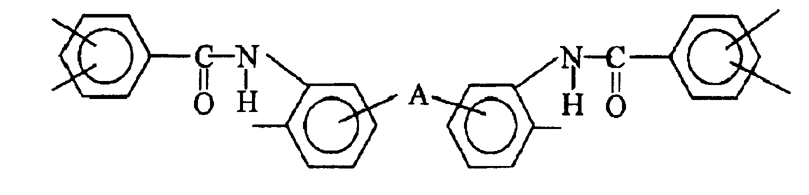

In the above formulae, A represents -CH₂-, -C(CH₃)₂-, -O-, -S-, -SO₂-, -CO-, -NHCO-, -C(CF₃)₂-, or a single bond.

R₁₅ represents an alkyl group or a halogen atom. r represents an integer of from 0 to 2. A plurality of R₁₅'s may be the same or different.

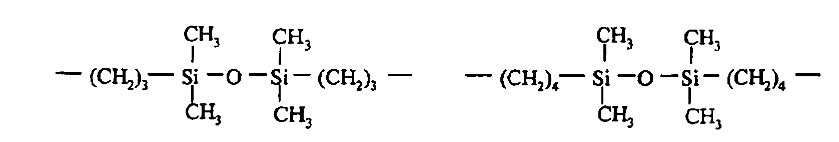

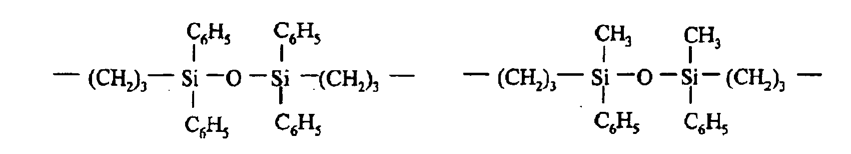

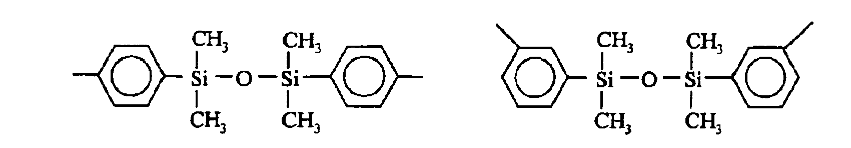

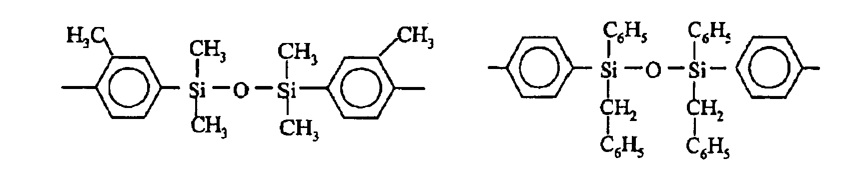

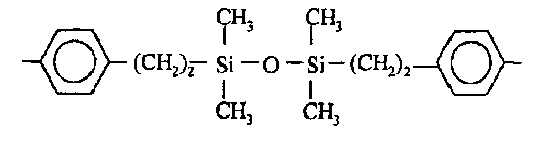

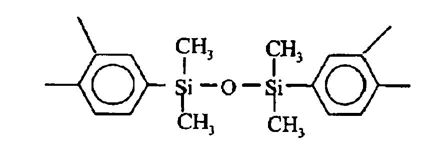

As particularly preferred groups of these, the following groups are exemplified.

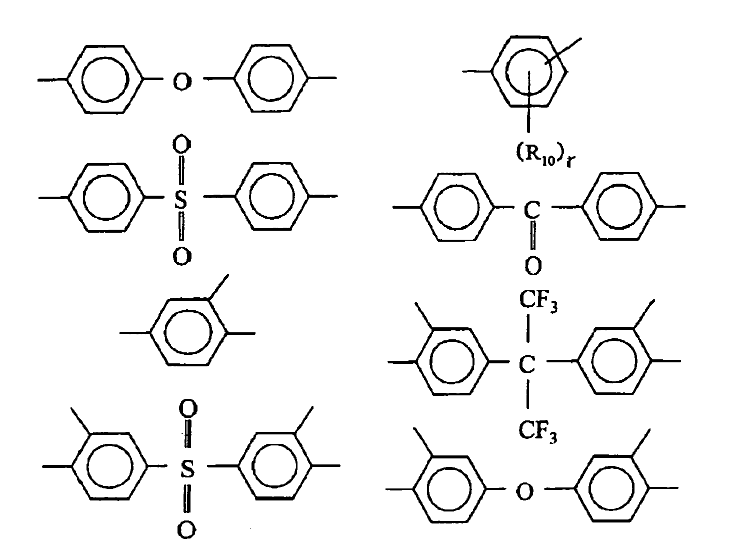

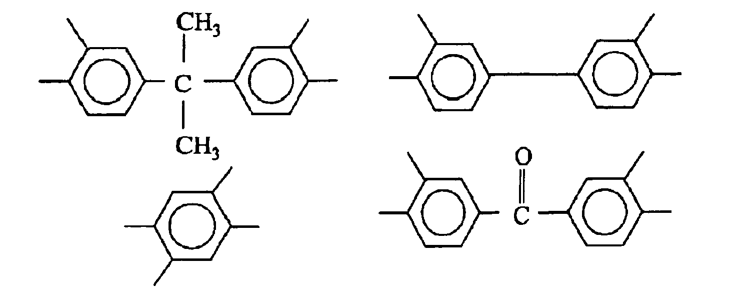

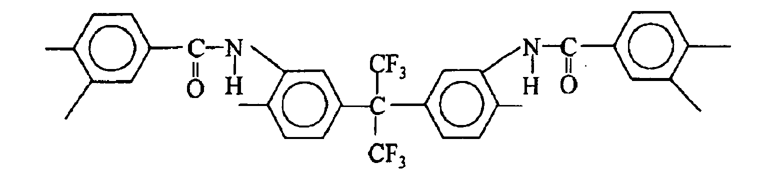

R₁₀ represents an alkyl group or a halogen atom. r represents an integer of from 0 to 2. A plurality of R₁₀' s may be the same or different.

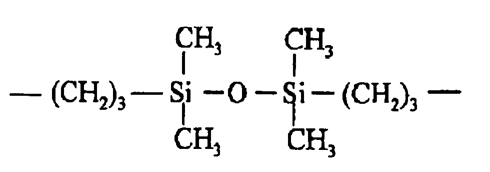

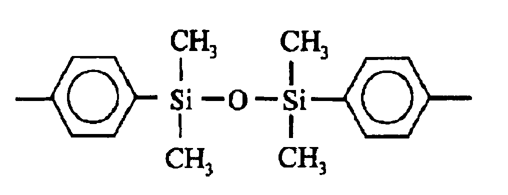

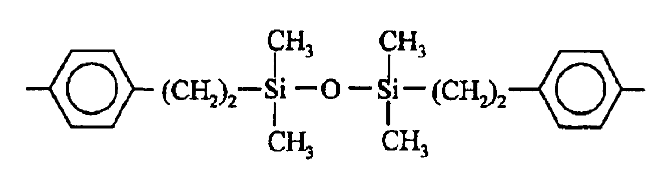

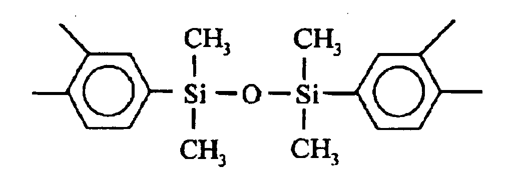

From the point of preservation stability, it is preferred that terminals are sequestered. For sequestering terminals, a derivative containing an aliphatic group having at least one alkenyl group or alkynyl group, or containing a cyclic compound group can be introduced to the terminals of the polyamide represented by formula (2) as acid derivative or amine derivative. Specifically, after synthesizing the polyamide resin containing the structure represented by formula (2) by the reaction of a compound selected from diamine or bis(aminophenol), 2,4-diaminophenol, etc., having the structure of X, silicone diamine having the structure of Z that is blended according to necessity, and a compound selected from tetracarboxylic anhydride, trimellitic anhydride, dicarboxylic acid, dicarboxylic acid dichloride, dicarboxylic acid derivative, hydroxydicarboxylic acid, hydroxy- dicarboxylic acid derivative, etc., having the structure of Y, it is preferred to cap the terminal amino groups contained in the polyamide resin as amide with an acid anhydride or acid derivative containing an aliphatic group having at least one alkenyl group or alkynyl group, or containing a cyclic compound group. As the groups originating in the acid anhydride or acid derivative containing an aliphatic group having at least one alkenyl group or alkynyl group, or containing a cyclic compound group after reaction with the amino groups, for example, the following groups are exemplified but the invention is not restricted thereto.

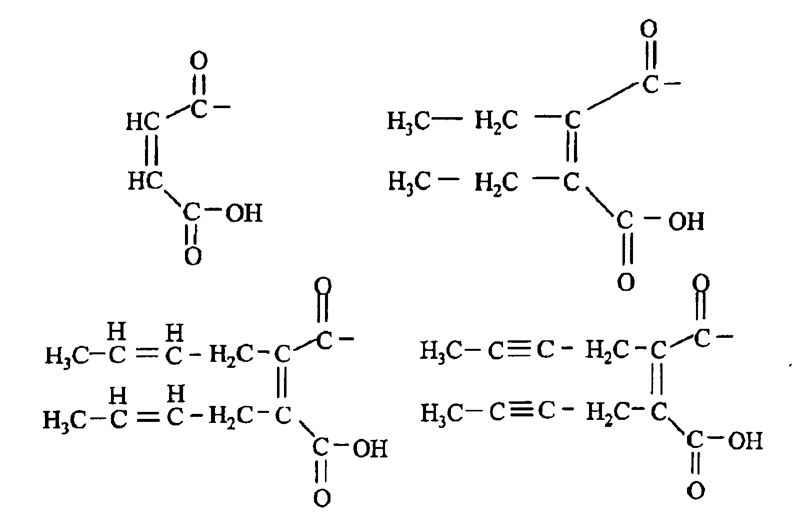

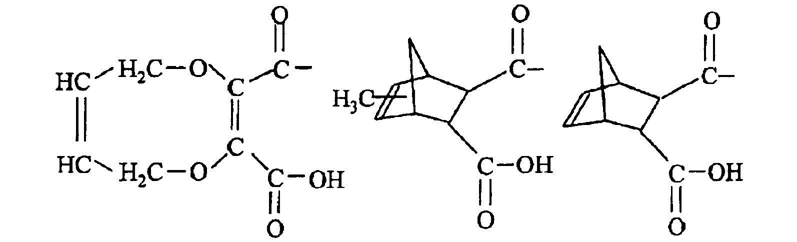

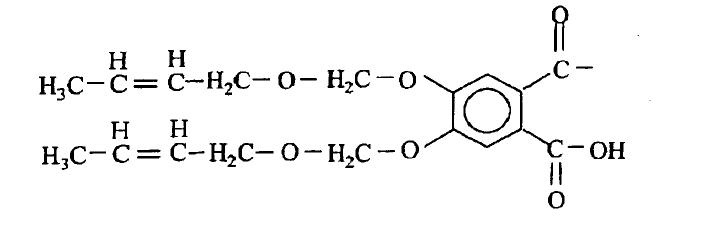

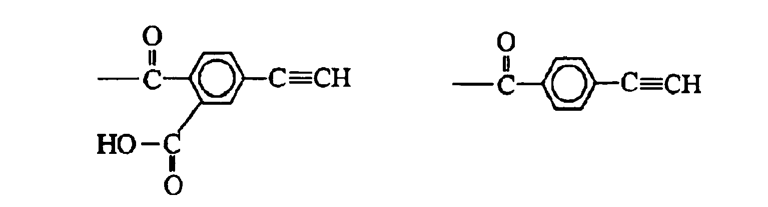

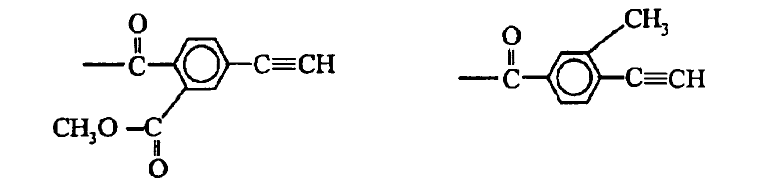

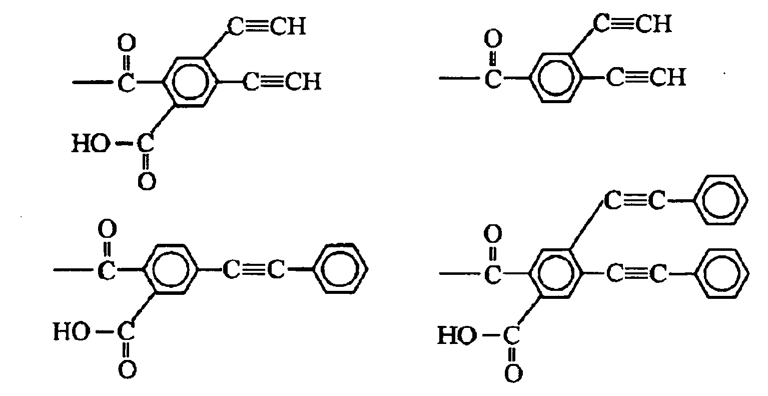

As particularly preferred groups of these, the following groups can be exemplified.

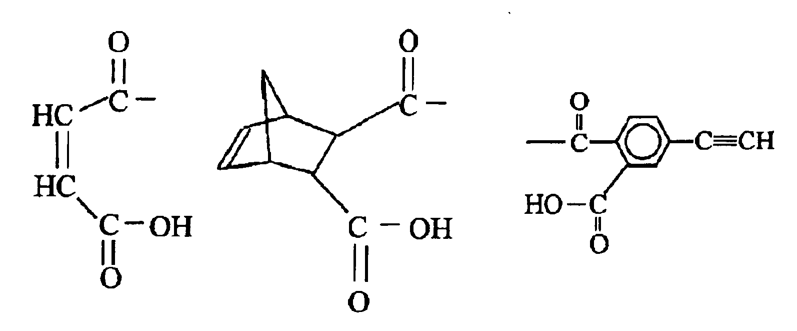

Two or more groups may be used. Further, the invention is not restricted to the above method, and the terminal acid contained in the polyamide resin can also be capped as amide with an amine derivative containing an aliphatic group having at least one alkenyl group or alkynyl group, or containing a cyclic compound group.

Further, as Z, which is used according to necessity, in the polyamide resin containing the structure represented by formula (2), the following structures are exemplified, but the invention is not restricted thereto, and two or more groups may be used.

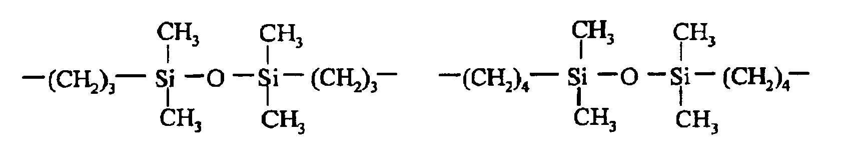

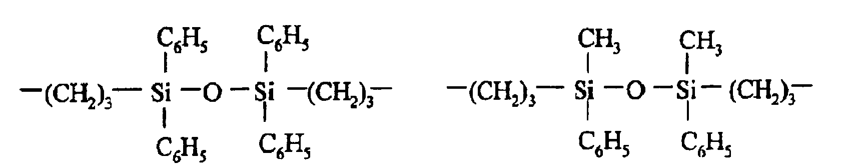

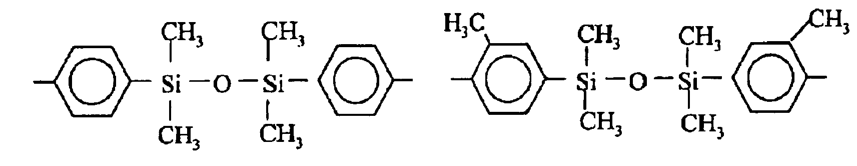

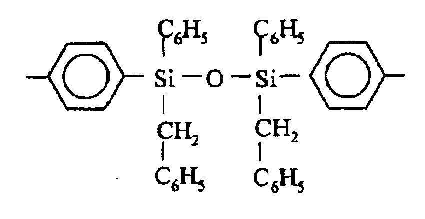

As polybenzoxazole precursors (PBO precursors), those disclosed in U.S. Patent 4, 371, 685 and JP-T-2002-526795 (the term "JP-T" as used herein refers to a "published Japanese translation of a PCT application") are exemplified. For example, polybenzoxazole precursor polymer (G) having a structure shown below can be exemplified.

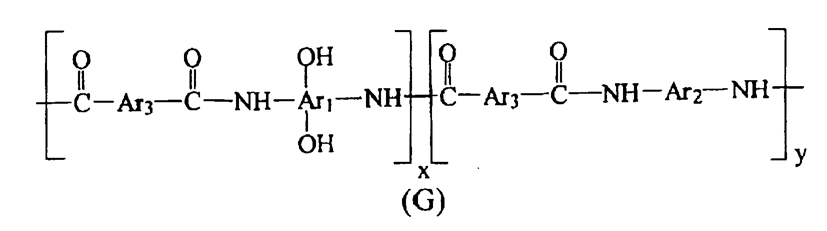

In formula (G), Ar₁ represents a tetravalent aromatic group, aliphatic group, heterocyclic group, or a mixed group of these groups; Ar₂ represents a divalent aromatic group, heterocyclic group, alicyclic group, or aliphatic group, which may or may not contain silicon according to cases; Ar₃ represents a divalent aromatic group, aliphatic group, heterocyclic group, or a mixed group of these groups; x represents from 5 to 1,000; and y represents from 0 to 900.

The intrinsic viscosity of PBO precursors at 25°C in concentration of 0.5 g/dL measured in NMP is preferably from 0.1 to 0.7 dL/g, and more preferably from 0.12 to 0.6 dL/g.

PBO precursors have the degree of polymerization of generally from 10 to 1,000, and synthesized by the reaction of the following monomers (A), (B) and (C) in the presence of a base.

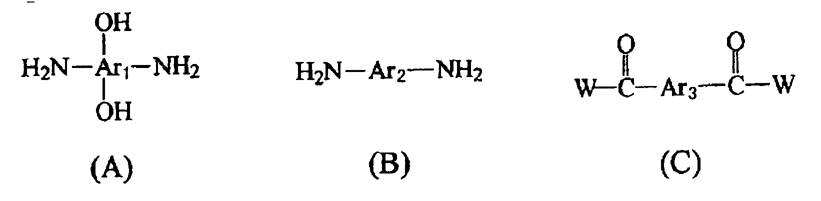

In the formulae, Ar₁, Ar₂, Ar₃, x and y are as defined above; W represents Cl, OR or OH; R represents an alkyl group or a cycloalkyl group, e.g., -CH₃, -C₂H₅, n-C₃H₇, i-C₃H₇, n-C₄H₉, t-C₄H₉, or cyclohexyl.

The ratio of [(A)+(B)]/(C) is generally between about 0.9 and 1.1. Monomer (A) is about 10 to 100 mol% of [(A)+(B)], and monomer (B) is about 0 to 90 mol% of [(A)+(B)].

PBO precursor (F) obtained by reacting the above polymer (G) and diazoquinone to partially cap the hydroxyl groups with the diazoquinone can be used in the invention.

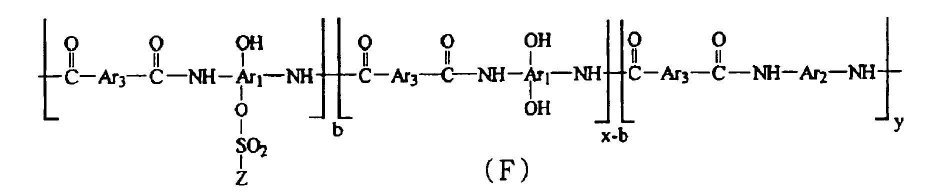

In formula (F), Ar₁, Ar₂ and Ar₃ are as defined above; x represents from 5 to 1,000; y represents from 0 to 900; and b represents from 0 to 50.

Z represents any of the following groups.

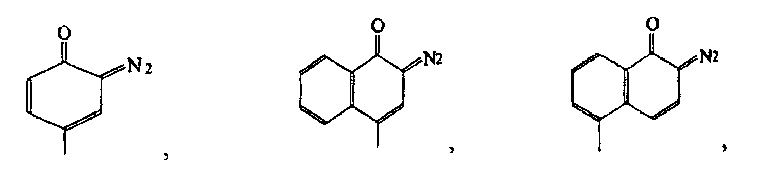

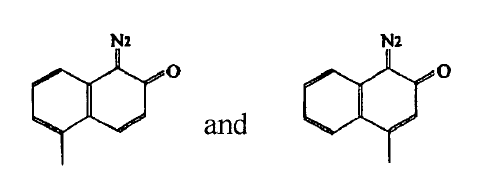

For example, it is possible to react polymer (G) with diazoquinone of about 1 to 35 mol%, with x being from 10 to 1,000, y from 0 to 900, and b from 0.10 to 350.

In monomer (A) that is the constituent of polymer (G) and polymer (F), Ar₁ represents a tetravalent aromatic group, aliphatic group, or heterocyclic group and, e.g., the following groups can be exemplified.

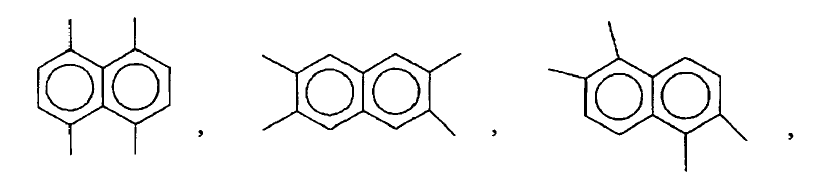

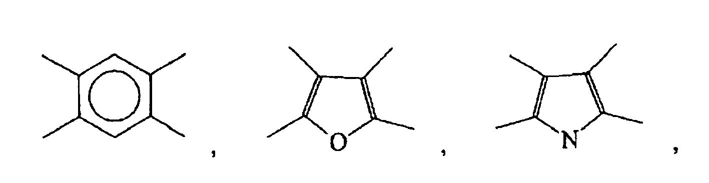

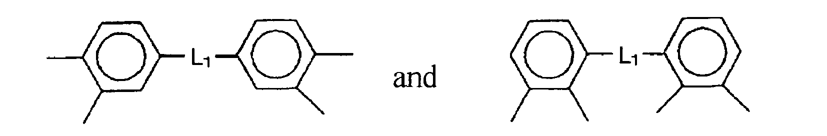

In the above formulae, L₁ represents -O-, -S-, -C(CF₃)₂-, -CH₂-, -SO₂-, -NHCO-, or the following group.

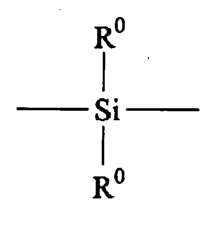

In the above formula, R⁰ each represents an alkyl group or a cycloalkyl group (e.g., -CH₃, -C₂H₅, n-C₃H₇, i-C₃H₇, n-C₄H₉, t-C₄H₉, or a cyclohexyl group).

Ar₁ is not restricted to these groups. Monomer (A) may be a mixture of two or more monomers.

In monomer (B) that is the constituent of precursor (G) and capped precursor (F), Ar₂ represents a divalent aromatic group, heterocyclic group, alicyclic group, or aliphatic group, which may or may not contain silicon.

The examples of monomers (B) containing Ar₂ include, e.g., 5(6)-diamino-1-(4-aminophenyl)-1,3,3-trimethylindane (DAPI), m-phenylenediamine, p-phenylenediamine, 2,2'-bis(trifluoromethyl)-4,4'-diamino-1,1'-biphenyl, 3,4'-diaminodiphenyl ether, 4,4'-diaminodiphenyl ether, 3,3'-diaminodiphenyl ether, 2,4-tolylenediamine, 3,3'-diaminodiphenylsulfone, 3,4'-diaminodiphenylsulfone, 4,4'-diaminodiphenylsulfone, 3,3'-diaminodiphenylmethane, 4,4'-diaminodiphenylmethane, 3,4'-diaminodiphenylmethane, 4,4'-diaminodiphenyl ketone, 3,3'-diaminodiphenyl ketone, 3,4'-diaminodiphenyl ketone, 1,3-bis(4-aminophenoxy)benzene, 1,3-bis(3-aminophenoxy)-benzene, 1,4-bis(γ-aminopropyl)tetramethyldisiloxane, 2,3,5,6-tetramethyl-p-phenylenediamine, m-xylylenediamine, p-xylylenediamine, methylenediamine, tetramethylenediamine, pentamethylenediamine, hexamethylenediamine, 2,5-dimethylhexamethylenediamine, 3-methoxyhexamethylenediamine, heptamethylenediamine, 2,5-dimethylheptamethylenediamine, 3-methylheptamethylenediamine, 4,4-dimethylheptamethylenediamine, octamethylenediamine, nonamethylenediamine, 2,5-dimethylnonamethylenediamine, docamethylenediamine, ethylenediamine, propylenediamine, 2,2-dimethylpropylenediamine, 1,10-diamino-1,10-dimethyldecane, 2,11-diaminododecane, 1,12-diaminooctadecane, 2,17-diaminoeicosane, 3,3'-dimethyl-4,4'-diaminodiphenylmethane, bis(4-aminocyclohexyl)methane, 3,3'-diaminodiphenylethane, 4,4'-diaminodiphenylethane, 4,4'-diaminodiphenyl sulfide, 2,6-diaminopyridine, 2,5-diaminopyridine, 2,6-diamino-4-trifluoromethylpyridine, 2,5-diamino-1,3,4-oxadiazole, 1,4-diaminocyclohexane, piperazine, 4,4'-methylenedianiline, 4,4'-methylenedi-bis(o-chloroaniline), 4,4'-methylene-bis-(3-methylaniline), 4,4'-methylene-bis(2-ethylaniline), 4,4'-methylene-bis(2-methoxyaniline), 4,4'-oxy-dianiline, 4,4'-oxy-bis(2-methoxyaniline), 4,4'-oxy-bis(2-chloroaniline), 4,4'-thio-dianiline, 4,4'-thio-bis(2-methyl- aniline), 4,4'-thio-bis(2-methoxyaniline), 4,4'-thio-bis-(2-chloroaniline), 3,3'-sulfonyl-dianiline, and mixtures of these compounds, but the invention is not restricted thereto. However, it should be construed that monomer (B) is not restricted thereto.

In monomer (C) that is the constituent of PBO precursor (G) and capped precursor (F), Ar₃ represents a divalent aromatic group, aliphatic group or heterocyclic group, and, e.g., the following groups are exemplified.

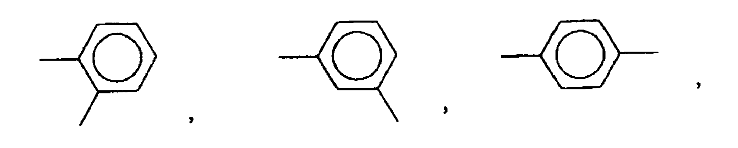

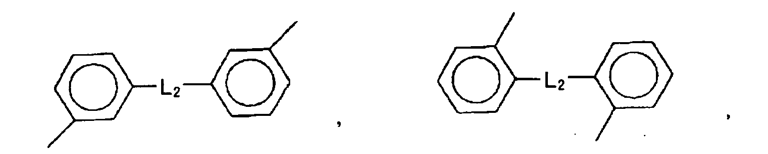

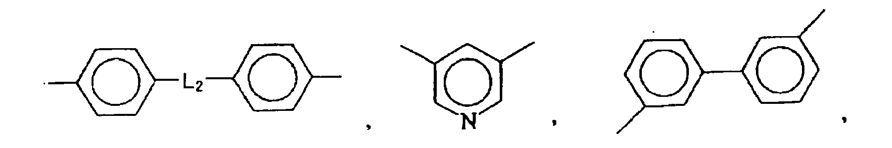

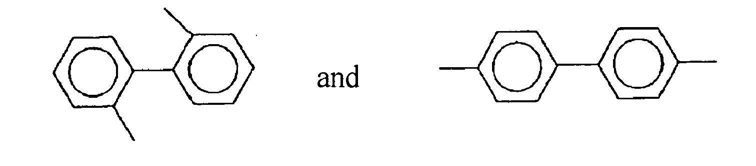

In the above formulae, L₂ represents -O-, -S-, -C (CF₃) ₂-, -CH₂-, -SO₂- or -NHCO-.

Ar₃ is not restricted to these groups. Monomer (C) may be a mixture of two or more monomers.

As the dizoquinone compounds to be reacted with PBO precursor (G), e.g., the following compounds are exemplified, and two or more dizoquinone compounds may be used.

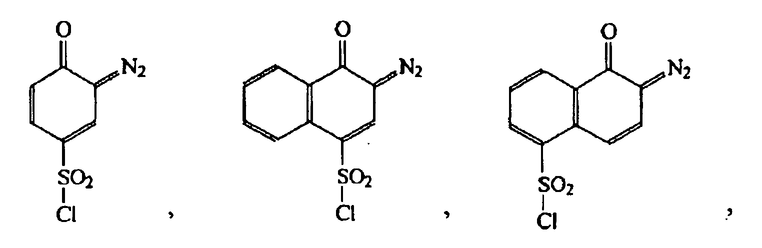

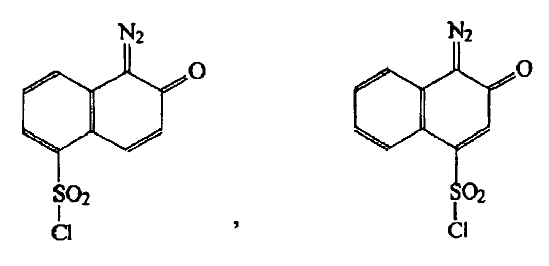

The examples of preferred reaction solvents include N-methyl-2-pyrrolidone (NMP), γ-butyrolactone (GBL), N,N-dimethylformamide (DMF), N,N-dimethylacetamide (DMAc), dimethyl-2-piperidone, dimethyl sulfoxide (DMSO), sulforan, and diglyme. The most preferred solvents are N-methyl-2-pyrrolidone (NMP) and γ-butyrolactone (GBL). For reacting a dicarboxylic acid or the chloride or ester thereof with at least one aromatic and/or heterocyclic dihydroxydiamine, and in some case for reacting with at least one diamine, conventionally used reaction may be arbitrarily used. The examples of preferred dicarboxylic acids are selected from the group consisting of 4,4'-diphenyl ether dicarboxylic acid, terephthalic acid, isophthalic acid, and mixtures of these acids. The examples of preferred dihydroxydiamine compounds include 3,3'-dihydroxy-4,4'-diaminodiphenyl ether, 3,3'-dihydroxybenzidine, hexafluoro-2,2-bis-3-amino-4-hydroxy-phenylpropane, and mixtures of these compounds. The reaction is generally carried out at about -10 to about 30°C for about from 6 to 48 hours. The molar ratio of dicarboxylic acid to (diamine + dihydroxydiamine) is about 0.9 to 1.1/1.

A capped PBO precursor can be manufactured according to the following reaction.

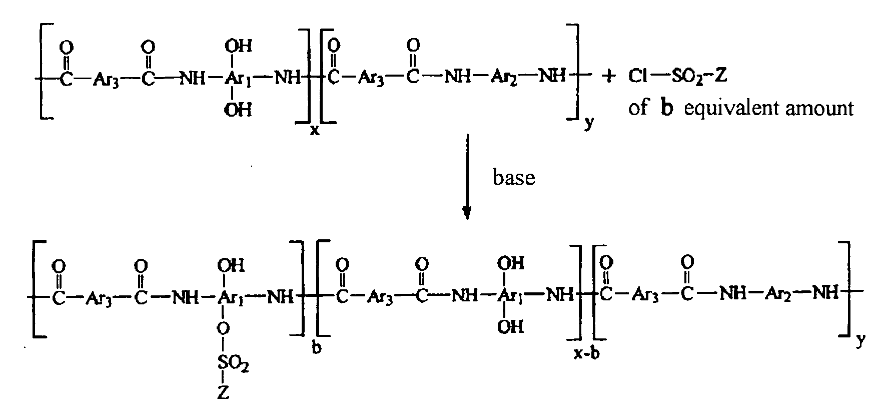

In the formula, Z has the same meaning as described above.

Preferred arbitrary methods can be used for reacting polybenzoxazole with photoactive moiety Cl-SO₂-Z. Generally the reaction is carried out in the presence of a base, e.g., pyridine, trialkylamine, methylpyridine, lutidine, or n-methylmorpholine, at about 0 to about 30°C for about 3 to 24 hours. The most preferred base is triethylamine.

The ratio of b/x is generally from 0.01 to 0.35, preferably from 0.02 to 0.20, and most preferably from 0.03 to 0.05.

The addition amount of a PBO precursor is generally from 50 to 99 mass% to the total solids content of the photosensitive resin composition of the invention (the total amount of the components constituting the finally obtained cured product exclusive of solvents), and preferably from 60 to 95 mass%.

As a preferred PBO precursor, a PBO precursor represented by any of formulae (A1-1), (A2-1) and (A3-1) can be exemplified.

### (A1) PBO precursor represented by formula (A1-1):

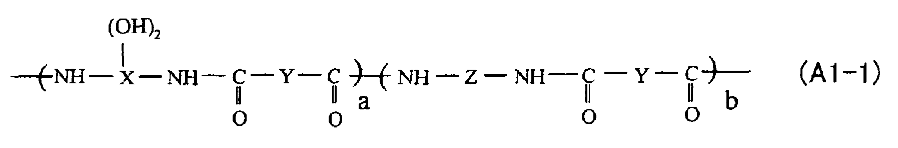

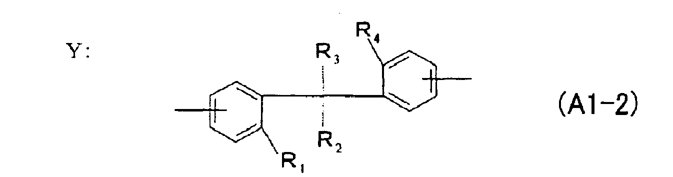

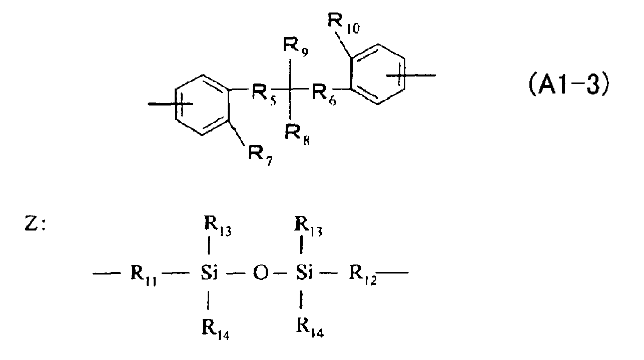

X represents a tetravalent organic group represented by formula (A1-4) shown below.

Y represents a divalent organic group represented by formula (A1-2) or (A1-3).

In formulae (A1-2) and (A1-3), R₁, R₂, R₃ and R₄ each independently represents a hydrogen atom or an organic group having from 1 to 4 carbon atoms, R₁ and R₂ and/or R₃ and R₄ may form a cyclic structure by the combination of divalent organic groups having from 1 to 4 carbon atoms that may contain a group selected from -O-, -S-, and >C=O, and the cyclic structure formed by R₁ and R₂ and the cyclic structure formed by R₃ and R₄ may be the same or different.

R₅ and R₆ each independently represents a group selected from a divalent organic group having from 1 to 3 carbon atoms, -0- and -S-.

R₇, R₈, R₉ and R₁₀ each independently represents a hydrogen atom or an organic group having from 1 to 4 carbon atoms, R₇ and R₈ and/or R₉ and R₁₀ may form a cyclic structure by the combination of divalent organic groups having from 1 to 4 carbon atoms that may contain a group selected from -O-, -S-, and >C=O, and the cyclic structure formed by R₇ and R₈ and the cyclic structure formed by R₉ and R₁₀ may be the same or different.

In the group represented by Z, R₁₁ and R₁₂ each independently represents a divalent organic group, and R₁₃ and R₁₄ each independently represents a monovalent organic group. a and b each represents a molar fraction, a+b is 100 mol%, a is from 60 to 100 mol%, and b is from 0 to 40 mol%.

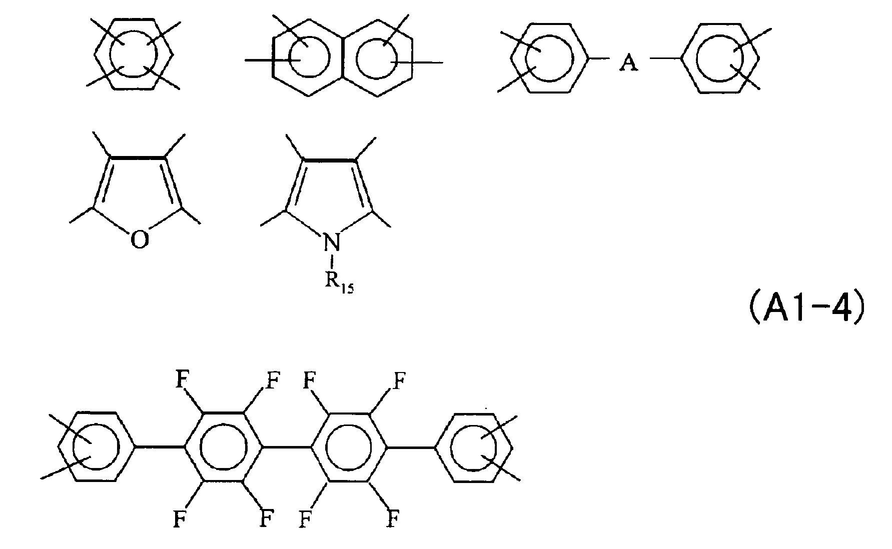

In formula (A1-4), A represents a single bond, -CH-, -C(CH₃)₂-, -O-, -S-, -SO₂-, -CO-, -NHCO- or -C(CF₃)-.

R₁₅ represents a hydrogen atom, an alkyl group, an alkyl ester group or a halogen atom.

Polyamide resin containing the structure represented by formula (A1-1) is resin obtained by the reaction of bis (aminophenol) having the structure of X and a compound selected from dicarboxylic acid, dicarboxylic acid dichloride and dicarboxylic acid derivative having the structure of Y. In the case of the dicarboxylic acid, for the purpose of increasing the reaction yield, dicarboxylic acid derivative of an active ester type reacted in advance with 1-hydroxy- 1,2,3-benzotriazole, etc., may be used.

3,3'-Diamino-4,4'-dihydroxybiphenyl is especially preferred as X in formula (A1-1). This structure is such a structure that the resin structure after curing has linearity, and the coefficient of linear expansion of a cured film becomes small and approaches the coefficient of linear expansion of an Si wafer, so that the warpage of an Si wafer is little.

As Y in formula (A1-1), the following specific examples can be exemplified, but the invention is not restricted thereto.

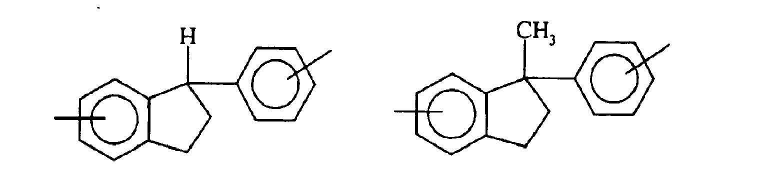

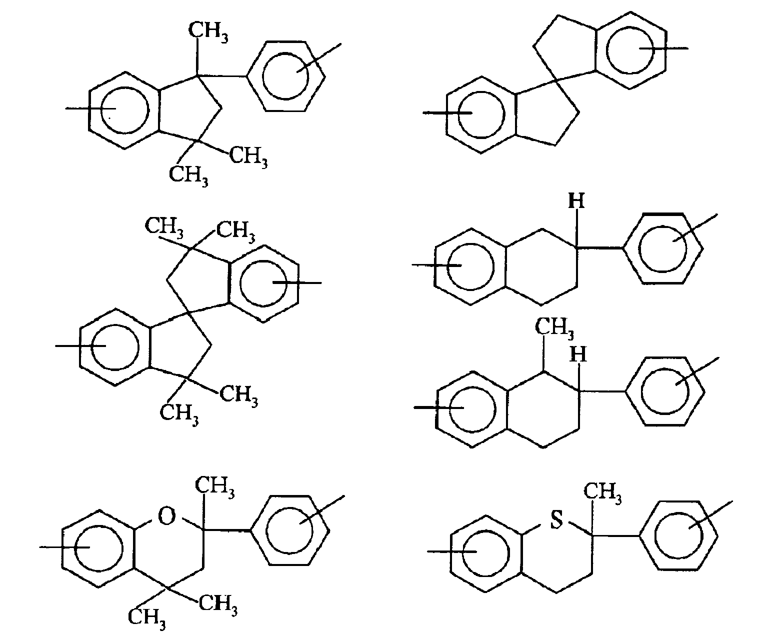

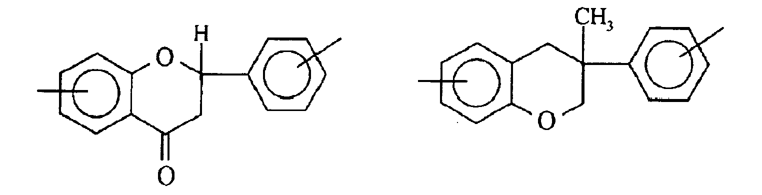

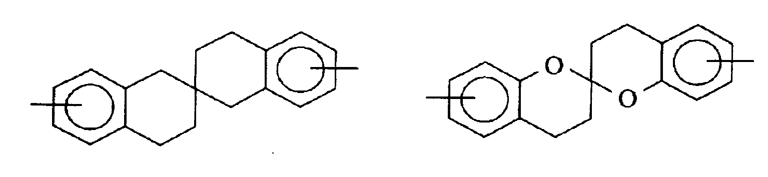

Especially preferred of these are 1,1,3-trimethyl-3-phenylindane-4',5-dicarboxylic acid, and 6,6'-dicarboxy-3,3,3',3'-tetramethyl-1,1-spiroindane. This structure is such a structure that heat resistance is given when a condensed ring is formed in the resin structure and at the same time the coefficient of linear expansion becomes small and approaches the coefficient of linear expansion of an Si wafer, so that the warpage of an Si wafer is little. On the other hand, since the double bond of a carbon ring is not contained in a part of the condensed ring and the resin structure is asymmetric or curved, intramolecular and intermolecular charge transfer is difficult to occur and light absorption is restrained, as a result transparency to i-line is improved.

The coefficient of linear expansion of resin after curing is preferably from 5 to 45 ppm. It is difficult to make the coefficient of linear expansion of resin after curing smaller than 5 ppm, and when the coefficient of linear expansion of resin after curing exceeds 45 ppm, warpage is liable to occur in a substrate such as an Si wafer and the like.

Further, as Z in the polyamide resin represented by formula (A1-1) used according to necessity, for example, the following structures are exemplified.

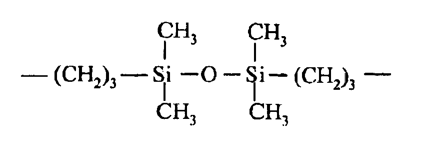

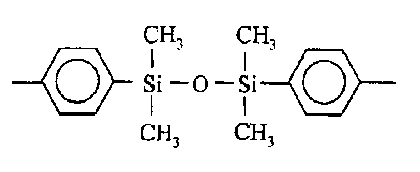

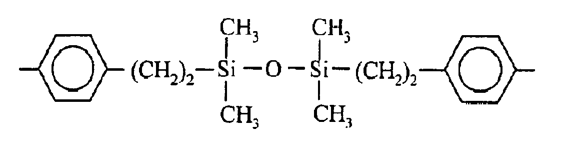

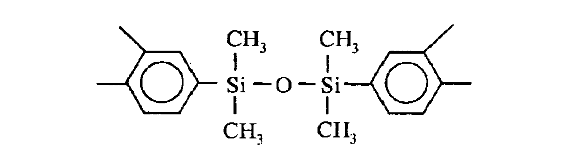

Z in formula (A1-1) is used, for example, when especially excellent adhesion to a substrate such as an Si wafer is required, and the maximum use proportion b is not higher than 40 mol%. When the use proportion exceeds 40 mol%, the solubility of the resin extremely lowers and development residue (scum) is generated, so that pattern processing is infeasible and not preferred. In using X, Y and Z, for increasing the solubility in an organic solvent, it is possible to copolymerize a mixture of two or more kinds within a degree that the coefficient of linear expansion of the resin is not too great.

In the invention, from the viewpoint of preservation stability, it is preferred that terminals are sequestered. For sequestering terminals, a derivative containing an aliphatic group having at least one alkenyl group or alkynyl group, or containing a cyclic compound group can be introduced to the terminals of polyamide represented by formula (A1-1) as acid derivative or amine derivative. Specifically, for example, after synthesizing a polyamide resin containing the structure represented by formula (A1-1) by the reaction of bis (aminophenol) having the structure of X and a compound selected from dicarboxylic acid, dicarboxylic acid dichloride and dicarboxylic acid derivative having the structure of Y, it is preferred to cap the terminal amino groups contained in the polyamide resin as amide with an acid anhydride or acid derivative containing an aliphatic group having at least one alkenyl group or alkynyl group, or containing a cyclic compound group. As the groups originating in the acid anhydride or acid derivative containing an aliphatic group having at least one alkenyl group or alkynyl group, or containing cyclic compound group after reaction with the amino group, for example, the following structures are exemplified.

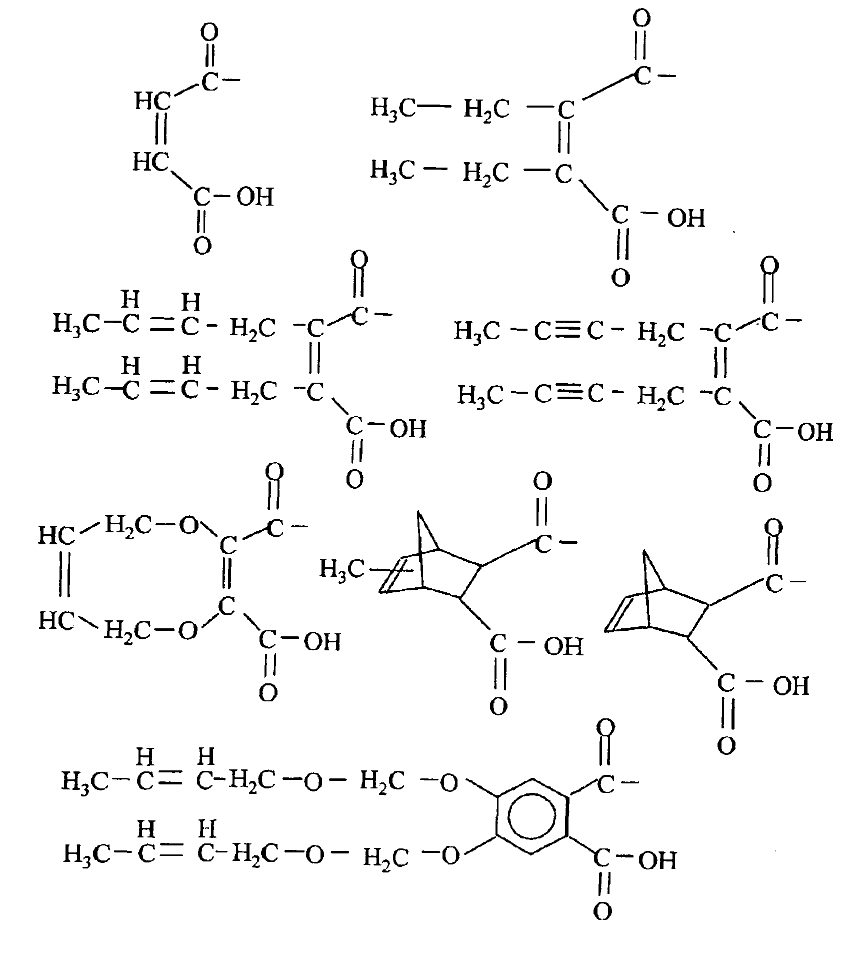

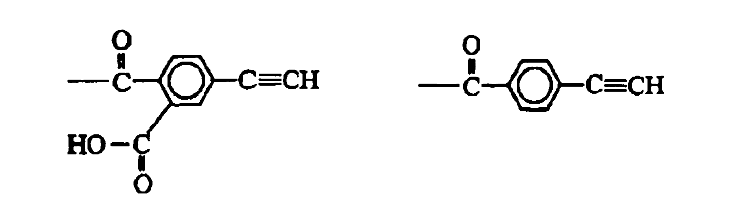

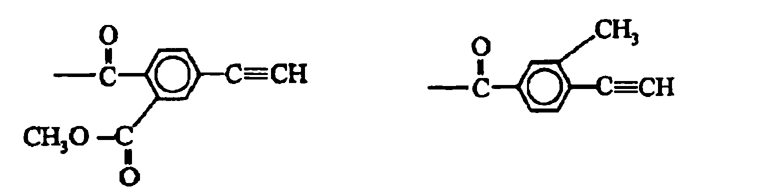

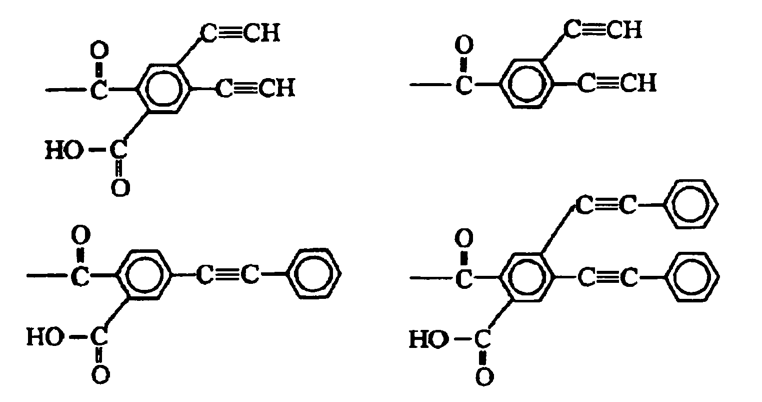

Of these structures, the following structures are especially preferred.

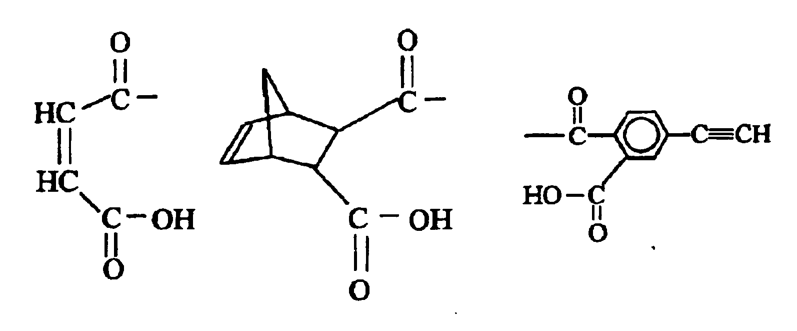

Two or more structures may be used. Further, the invention is not restricted to the above method, and the terminal acid contained in the polyamide resin can also be capped as amide with an amine derivative containing an aliphatic group having at least one alkenyl group or alkynyl group, or containing a cyclic compound group.

### (A2) Polybenzoxazole precursor represented by formula (A2-1):

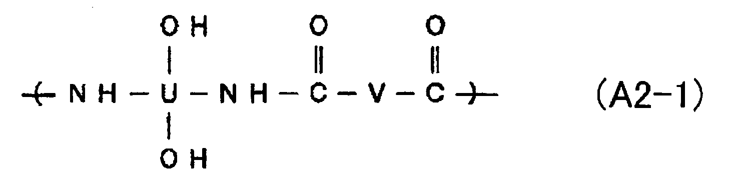

In formula (A2-1), U represents a tetravalent organic group, and V represents a divalent organic group.

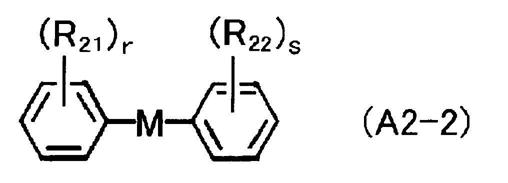

In formula (A2-2), M represents a single bond or a divalent group; R₂₁ and R₂₂ each independently represents a fluorine atom or a monovalent organic group; and r and s each independently represents an integer of from 1 to 4.

All the bonding hands on the structure to the amido group or OH group in formula (A2-1) are present on the aromatic rings.

In the invention, the tetravalent organic group represented by U in formula (A2-1) is generally a diamine residue having a structure that each of two hydroxyl groups reacting with dicarboxylic acid and forming a polyamide structure is positioned on the ortho-position of the amine. On the other hand, the divalent organic group represented by V in formula (A2-1) is generally a dicarboxylic acid residue forming a polyamide structure by reacting with diamine.

As the examples of the divalent groups represented by M, -CH₂-, -C(CH₃)₂-, -O-, -S-, -SO₂- -CO-, -(CF₃)₂-, etc., are preferably exemplified. From the aspect of stress, a single bond is most preferred.

As the examples of the monovalent organic groups represented by R₂₁ and R₂₂, an alkyl group, an alkyl ether group, a fluoroalkyl group, and a fluoroalkyl ether group, each group having from 1 to 10 carbon atoms, are preferably exemplified. As the integers represented by r and s, each preferably represents 1 or 2. The bonding positions of the groups are preferably the ortho-positions to M in view of transparency and the like.

The structure represented by formula (A2-2) is preferably a structure represented by the following formula (A2-3).

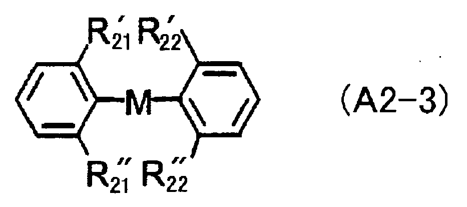

In formula (A2-3), R₂₁', R₂₁", R₂₂' and R₂₂" each independently represents a hydrogen atom, a fluorine atom, or a monovalent organic group (an alkyl group, an alkyl ether group, a fluoroalkyl group, a fluoroalkyl ether group, etc., each having from 1 to 10 carbon atoms). At least one of R₂₁' and R₂₁", and at least one of R₂₂' and R₂₂" represent a fluorine atom or a monovalent organic group, and more preferably a monovalent organic group.

For the reason of capable of obtaining a polymer of low stress and high transparency, M most preferably represents a single bond, and R₂₁' , R₂₁", R₂₂' and R₂₂" each preferably represents a methyl group, a trifluoromethyl group, an ethyl group, an isopropyl group, or a t-butyl group.

As diamine components to provide the structure represented by formula (A2-2) (including the structure represented by formula (A2-3)), 2,2'-bis(trifluoromethyl)-bis(3-hydroxy-4-amino)biphenyl, 2,2'-dimethyl-bis(3-hydroxy-4-amino)biphenyl, and bis(3-amino-4-hydroxy-6-methylphenyl)sulfone are exemplified, and as similar dicarboxylic acids, 2,2'-dimethyl-4,4'-biphenylcarboxylic acid, 2,2'-bis(trifluoromethyl)-4,4'-biphenylcarboxylic acid, 4,4'-dicarboxy-2,2'-dimethyldiphenyl ether, etc., are exemplified.

It is sufficient for the aromatic polyamide having the repeating unit represented by formula (A2-1) for use in the invention to have a structure represented by formula (A2-2), but may have U or V of other structures. These are the structures other than the structure represented by formula (A2-2), and a divalent or tetravalent aromatic group or aliphatic group having from 4 to 40 carbon atoms is preferred, and a divalent or tetravalent aromatic group having from 4 to 40 carbon atoms is more preferred.

As diamines to provide such U, 3,3'-diamino-4,4'-dihydroxybiphenyl, 4,4'-diamino-3,3'-dihydroxybiphenyl, bis(3-amino-4-hydroxyphenyl)propane, bis(4-amino-3-hydroxyphenyl)propane, bis(3-amino-4-hydroxyphenyl)sulfone, bis(4-amino-3-hydroxyphenyl)sulfone, 2,2-bis(3-amino-4-hydroxyphenyl)-1,1,1,3,3,3-hexafluoropropane, 2,2-bis(4-amino-3-hydroxyphenyl)-1,1,1,3,3,3-hexafluoropropane, bis(4-amino-3-hydroxyphenyl) ether, bis(3-amino-4-hydroxyphenyl) ether, etc., are exemplified. Of these compounds, the compounds preferred in the points of transparency and the like are 3,3'-diamino-4,4'-dihydroxybiphenyl, 4,4'-diamino-3,3'-dihydroxybiphenyl, bis(3-amino-4-hydroxyphenyl)propane, 2,2-bis(3-amino-4-hydroxyphenyl)-1,1,1,3,3,3-hexafluoropropane, and 2,2-bis(4-amino-3-hydroxyphenyl)-1,1,1,3,3,3-hexafluoropropane. As the compounds preferred in the point of low stress, 3,3'-diamino-4,4'-dihydroxybiphenyl, 4,4'-diamino-3,3'-dihydroxybiphenyl, and the following structures are exemplified.

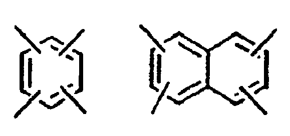

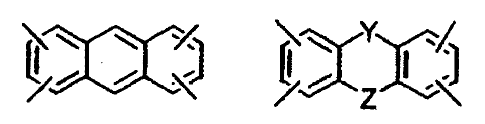

In the above, Y and Z each independently represents a single bond or a divalent group, and as the divalent group, -CH₂-, -C(CH₃)₂-, -O-, -S-, -SO₂-, -CO-, and -(CF₃)₂- are preferably exemplified.

These compounds can be used alone, or two or more in combination.

As dicarboxylic acids to give such V, aromatic dicarboxylic acids such as isophthalic acid, terephthalic acid, 2,2-bis(4-carboxyphenyl)-1,1,1,3,3,3-hexafluoropropane, 4,4'-dicarboxybiphenyl, 2,2'-dicarboxybiphenyl, 4,4'-dicarboxydiphenyl ether, 4,4'-dicarboxytetraphenylsilane, bis(4-carboxyphenyl)sulfone, 2,2-bis(p-carboxyphenyl)- propane, 5-tert-butylisophthalic acid, 5-bromoisophthalic acid, 5-fluoroisophthalic acid, 5-chloroisophthalic acid, and 2,6-naphthalenedicarboxylic acid, and aliphatic dicarboxylic acids such as 1,2-cyclobutanedicarboxylic acid, 1,4-cyclohexanedicarboxylic acid, 1,3-cyclopentanedicarboxylic acid, oxalic acid, malonic acid, and succinic acid are exemplified. Of these compounds, the compounds preferred in the points of transparency and the like are isophthalic acid, 2,2-bis(4-carboxyphenyl)-1,1,1,3,3,3-hexafluoropropane, 4,4'-dicarboxydiphenyl ether, and aliphatic dicarboxylic acids.

In the point of low stress, 4,4'-dicarboxybiphenyl, 2,2'-dicarboxybiphenyl, terephthalic acid, 2,6-naphthalenedicarboxylic acid, and the following structures are preferred.

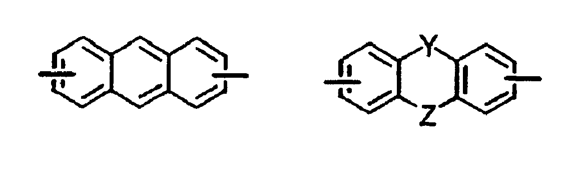

In the above, Y and Z each independently represents a single bond or a divalent group, and as the divalent group, -CH₂-, -C(CH₃)₂-, -O-, -S-, -SO₂-, -CO-, and -(CF₃)₂- are preferably exemplified.

These compounds can be used alone, or two or more in combination.

In the formulae of the polyamide, repeating units other than the repeating unit represented by formula (A2-1) may be used.

The solubility of polyamide in an alkali aqueous solution resulting from a phenolic hydroxyl group, it is preferred that an amide unit containing a hydroxyl group is contained beyond a certain proportion. In this case, polyamide represented by the following formula is preferred.

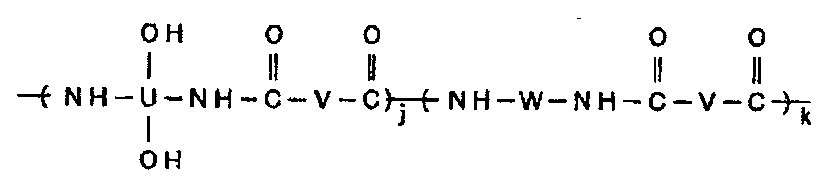

In the above formula, U and V respectively have the same meaning as U and V in formula (A2-1); W represents a divalent organic group; j and k each represents a molar fraction, the sum of j and k is 100 mol%, j is from 60 to 100 mol%, and k is from 40 to 0 mol%.

Here, the molar fraction of j in the formula is preferably from 80 to 100 mol%, and that of k is from 20 to 0 mol%.

The divalent organic group represented by W is generally a residue of diamine reacting with dicarboxylic acid and forming a polyamide structure, which is a residue other than the diamine forming U. The divalent organic group is preferably a divalent aromatic group or aliphatic group having from 4 to 40 carbon atoms, and a divalent aromatic group having from 4 to 40 carbon atoms is more preferred.

As such diamines, aromatic diamine compounds, e.g., 4,4'-diaminodiphenyl ether, 4,4'-diaminodiphenylmethane, 4,4'-diaminodiphenylsulfone, 4,4'-diaminodiphenyl sulfide, benzidine, m-phenylenediamine, p-phenylenediamine, 1,5-naphthalenediamine, 2,6-naphthalenediamine, bis(4-aminophenoxyphenyl)sulfone, bis(3-aminophenoxyphenyl)- sulfone, bis(4-aminophenoxy)biphenyl, bis [4-(4-amino- phenoxy)phenyl] ether, 1,4-bis(4-aminophenoxy)benzene and the like, in addition to these, as diamines containing a silicon group, LP-7100, X-22-161AS, X-22-161A, X-22-161B, X-22-161C, and X-22-161E (trade names, manufactured by Shin-Etsu Chemical Co., Ltd.) are exemplified, but the invention is not restricted thereto. These compounds are used alone or combination of two or more.

In this case, it is preferred that W also has the structure represented by formula (A2-2).

The terminal group of the aromatic polyamide represented by formula (A2-1) becomes amine having a carboxylic acid or a phenol group by the charge ratio of U and V. If necessary, one or both terminals of a polymer may be made a saturated aliphatic group, an unsaturated aliphatic group, a carboxyl group, a phenolic hydroxyl group, a sulfonic acid group, or a thiol group by the reaction of polymer terminals with a single or two kinds of end-capping agents. At that time, end-capping rate is preferably from 30 to 100%.

The molecular weight of the PBO precursor represented by formula (A2-1) is preferably from 3,000 to 200,000 as weight average molecular weight, and more preferably from 5, 000 to 100, 000. The molecular weight here is a value obtained by the measurement according to gel permeation chromatography and conversion from the standard polystyrene calibration curve.

In the invention, polyamide having a repeating unit represented by formula (A2-1) can be generally synthesized from a dicarboxylic acid derivative and hydroxyl group-containing diamines. Specifically, the polyamide can be synthesized, after converting a dicarboxylic acid derivative to a dihalide derivative, by the reaction with the diamines. As the dihalide derivative, a dichloride derivative is preferred.

The dichloride derivative can be synthesized by the reaction of a dicarboxylic acid derivative with a halogenating agent. As the halogenating agents, thionyl chloride, phosphoryl chloride, phosphorus oxychloride, and phosphorus pentachloride that are used in ordinary acid chloride reaction of carboxylic acid can be used.

Dichloride derivatives can be synthesized by a method of reacting dicarboxylic acid derivative with the halogenating agent in a solvent, or by a method of performing the reaction in an excess amount of halogenating agent, and then distilling off the excess halogenating agent. As the reaction solvents, N-methyl-2-pyrrolidone, N-methyl-2-pyridone, N,N-dimethylacetamide, N,N-dimethylformamide, toluene, benzene, etc., can be used.

The use amount of the halogenating agents is preferably from 1.5 to 3.0 mol to the dicarboxylic acid derivative in the case of reaction in a solvent, more preferably from 1.7 to 2.5 mol, and from 4.0 to 50 mol in the case of reaction in a halogenating agent, and more preferably from 5.0 to 20 mol. The temperature of reaction is preferably from -10 to 70°C, and more preferably from 0 to 20°C.

The reaction of a dichloride derivative with diamines is preferably performed in an organic solvent in the presence of a dehydrohalogenating agent. As the dehydrohalogenating agent, organic bases such as pyridine and triethylamine are generally used. Further, as the organic solvents, N-methyl-2- pyrrolidone, N-methyl-2-pyridone, N,N-dimethylacetamide, and N,N-dimethylformamide can be used. The temperature of reaction is preferably from -10 to 30°C, and more preferably from 0 to 20°C.

### (A3) Polybenzoxazole precursor represented by formula (A3-1):

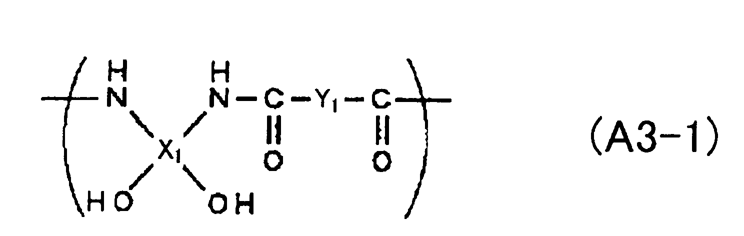

In formula (A3-1), X₁ represents a tetravalent organic group having an aromatic ring; Y₁ represents a divalent organic group; two OH's and two NH's bonding to X₁ are each a set of one OH and one NH, and OH and NH in each set are positioned on the ortho position of the aromatic ring, and the total number of the aromatic rings contained in X₁ and Y₁ is 3 or less.

The hydroxyl group concentration of the PBO precursor represented by formula (A3-1) is preferably 3.35 mol/kg or more when not containing a fluorine atom, and the hydroxyl group concentration is preferably 2.00 mol/kg or more when containing a fluorine atom. Further, the transmittance of ray of light of 365 nm per 10 µm of the thickness of the film formed of the PBO precursor is preferably 1% or more.

The above PBO precursor is preferably a PBO precursor having a repeating unit represented by the following formula (A3-2).

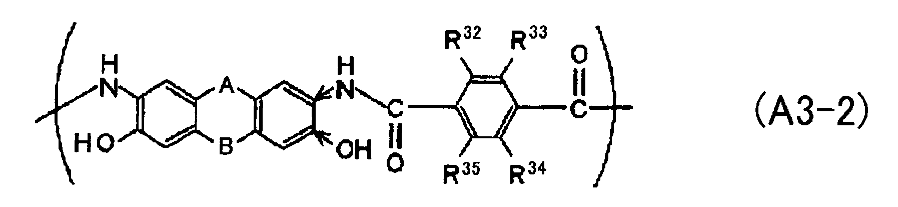

In formula (A3-2), A and B each independently represents a divalent group that does not conjugate with the benzene ring to which A or B is bonded, or a single bond; R³², R³³, R³⁴ and R³⁵ each independently represents a monovalent group, and the bonds shown by two arrows mean that they may be bonded inversely.

In formula (A3-1), X₁ represents a tetravalent organic group having an aromatic ring, which is generally a dihydroxydiamine residue forming the structure of a PBO precursor by the reaction with dicarboxylic acid. Two OH's and two NH's bonding to X₁ are each a set of one OH and one NH, and OH and NH in each set are positioned on the ortho position of the aromatic ring. As the tetravalent organic group having an aromatic ring represented by X₁, groups having at least one aromatic ring (e.g., a benzene ring, a naphthalene ring, etc.) and from 6 to 20 carbon atoms are exemplified, and these groups may have various substituents such as an alkyl group, an alkoxyl group, a halogen atom, and a halogenated alkyl group.

The divalent organic group represented by Y₁ in formula (A3-1) is a dicarboxylic acid residue generally forming the structure of a PBO precursor by reacting with dihydroxydiamine. As the divalent organic group having an aromatic ring represented by Y₁, groups having at least one aromatic ring (e.g., a benzene ring, a naphthalene ring, etc.) and from 6 to 20 carbon atoms are exemplified, and these groups may have various substituents. Having one aromatic ring contributes to solubility in an alkali aqueous solution and preferred.

In the repeating unit represented by formula (A3-1), the number of aromatic rings contained in X₁ and Y₁ is 3 or less. When the number of aromatic rings is 4 or more, it is difficult to reconcile low stress of the wafer and the solubility in an alkali aqueous solution. The hydroxyl group concentration of the PBO precursor in the invention is preferably 3.35 mol/kg or more when not containing a fluorine atom, preferably from 4.0 to 10.0 mol/kg, and hydroxyl group concentration is preferably 2.00 mol/kg or more when containing a fluorine atom, and preferably from 3.0 to 10.0 mol/kg. When the values are lower than these numerical values, the solubility in an alkali aqueous solution is insufficient.

The hydroxyl group concentration can be computed as the hydroxyl group content per mass of the repeating unit (the number of the hydroxyl groups/the mass of the repeating unit) on the basis of the kinds and amounts of the materials of the resin.

Further, it is preferred that the PBO precursor for use in the invention has transmittance of ray of light of wavelength of 365 nm per 10 µm of the thickness of the prebaked film formed of the PBO precursor of 1% or more, more preferably 5% or more, and still more preferably 10% or more. When the value is less than 1%, it is difficult to obtain a photosensitive resin composition capable of forming a pattern high in resolution and having a good shape. The particularly preferred transmittance is from 10 to 80%. The film of a PBO precursor can be manufactured by dissolving the PBO precursor in a solvent, coating the resulting solution on a substrate, and drying to form a film. The transmittance of light of wavelength of 365 nm of the film of a PBO precursor can be measured with a spectrophotometer (e.g., model U-3410, manufactured by Hitachi Limited). Even when a film thickness is not exactly 10 µm, it is possible to convert the film thickness per 10 µm according to Lambert's law.

The PBO precursor for use in the photosensitive resin composition of the invention preferably has a repeating unit having the structure represented by formula (A3-2), it is more preferred that the repeating unit represented by formula (A3-2) accounts for 50% or more of all the repeating units, still more preferably 80% or more, and especially preferably about 100%. In formula (A3-2), A and B each represents a divalent group that does not conjugate with the benzene ring to which A or B is bonded, and specifically a carbonyl group, an oxy group, a thio group, a sulfinyl group, a sulfonyl group, an alkylene group having from 1 to 5 carbon atoms that may have a substituent, an imino group that may have a substituent, a silylene group that may have a substituent, and groups formed by combination of these groups can be exemplified.

As the substituents that may be contained in each group as described in the explanation of A and B, monovalent and divalent substituents are exemplified, and specifically an alkyl group having from 1 to 10 carbon atoms that may be branched, an alkyl group having from 1 to 10 carbon atoms substituted with a halogen atom (e.g., chlorine, fluorine, iodine, bromine, etc.), an alkenyl group having from 1 to 10 carbon atoms, an alkynyl group having from 1 to 10 carbon atoms, an aromatic hydrocarbon group having from 6 to 20 carbon atoms, e. g. , a phenyl group and a benzyl group, an alkyloxy group having from 1 to 10 carbon atoms, an alkyloxy group having from 1 to 10 carbon atoms substituted with a halogen atom (e.g., chlorine, fluorine, iodine, bromine, etc.), a cyano group, a halogen atom (e.g., chlorine, fluorine, iodine, bromine, etc.), a hydroxyl group, an amino group, an azido group, a mercapto group, a trialkylsilyl group in which each alkyl group has from 1 to 5 carbon atoms, an alkylene group having from 2 to 5 carbon atoms, a carbonyl group, a carboxyl group, an imino group, an oxy group, a thio group, a sulfinyl group, a sulfonyl group, a dialkylsilylene group in which each alkyl group has from 1 to 5 carbon atoms, and substituents formed by combination of these groups can be exemplified. Of these groups, an alkyl group having from 1 to 5 carbon atoms, a halogen-substituted alkyl group having from 1 to 5 carbon atoms, an alkyloxy group having from 1 to 5 carbon atoms, a halogen-substituted alkyloxy group having from 1 to 5 carbon atoms, an aromatic hydrocarbon group, and an alkylene group having 2 or 3 carbon atoms are more preferred.

For capable of improving the transparency to i-line and reducing the stress of wafer, A and B each preferably independently represents a group selected from a single bond, O, CH₂, C=O, Si(CH₃)₂, C(CH₃)₂, C(CF₃)₂, C(CH₃)(CF₃), Si(OCH₃)₂, C(OCH₃)₂, C(OCF₃)₂, C(OCH₃)(OCF₃), S, SO₂, CH(CH₃), CH(CF₃), CH(OCH₃), CH(OCF₃), SiH(CH₃) and SiH(OCH₃).

As the monovalent group represented by R³², R³³, R³⁴ and R³⁵, a group selected from a hydrogen atom, an alkyl group having from 1 to 10 carbon atoms, CF₃, a halogen atom, COOH and OH is preferred in view of the transparency to i-line and the solubility in an alkali aqueous solution.

The PBO precursor for use in the invention can be synthesized by the reaction of dihydroxydiamine and dicarboxylic acid or a derivative thereof in an organic solvent used according to necessity.

As preferred dihydroxydiamine components, for example, the following compounds can be exemplified.

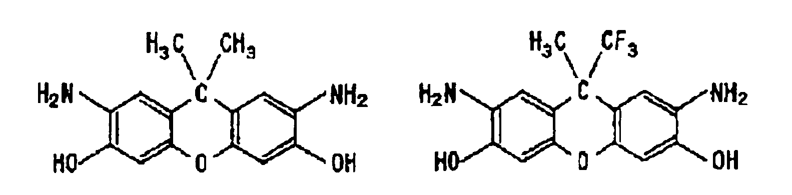

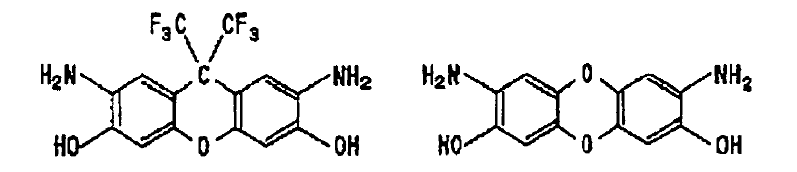

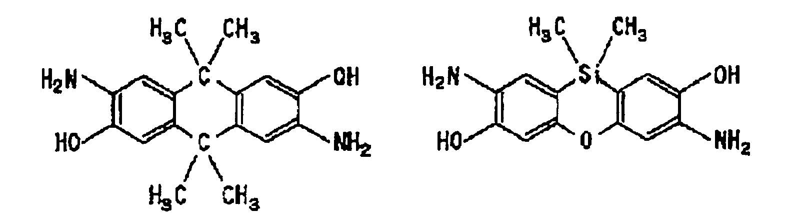

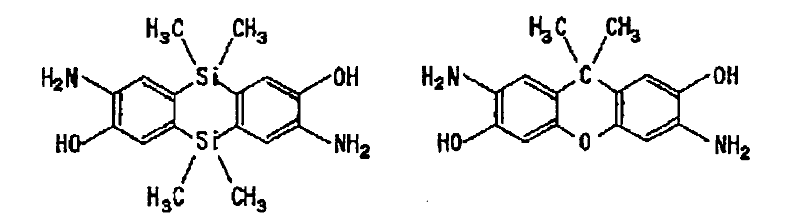

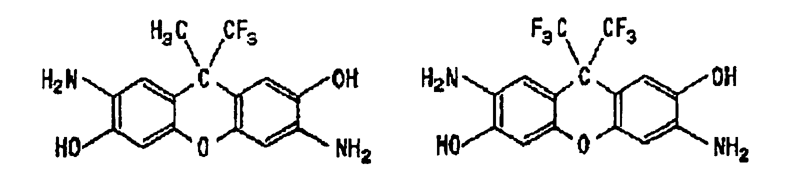

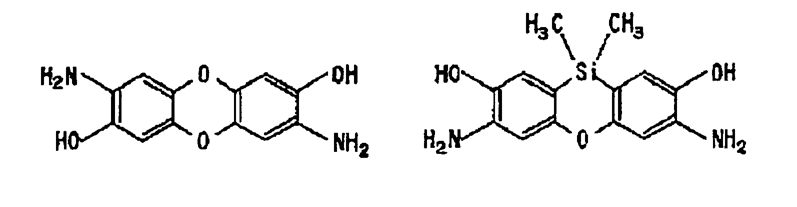

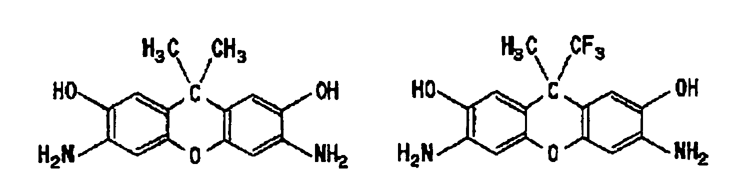

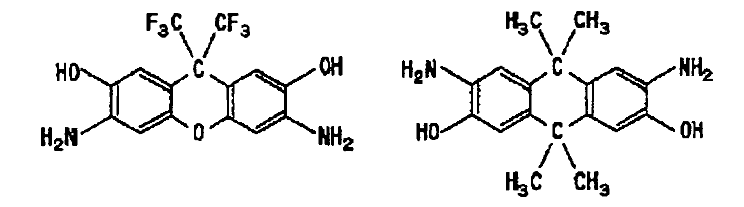

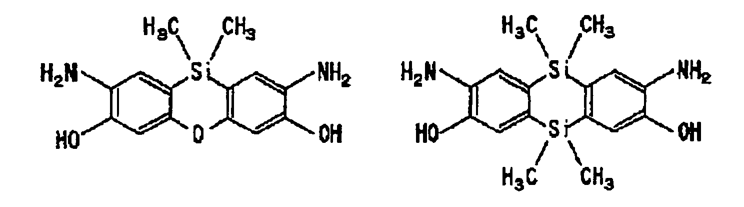

Further, diamines, e.g., 3,3'-diamino-4,4'-dihydroxydiphenyl ether, 4,4'-diamino-3,3'-dihydroxydiphenyl ether, and 2,2-bis(3-amino-4-hydroxyphenyl)hexafluoropropane can also be used.

As preferred dicarboxylic acid components, dicarboxylic acids having one benzene ring in which two carboxyl groups are bonded to the para-positions are exemplified and, for example, the following ones are preferably exemplified.

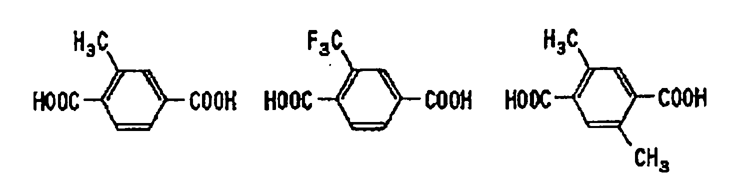

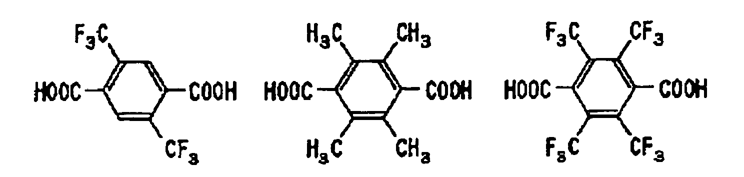

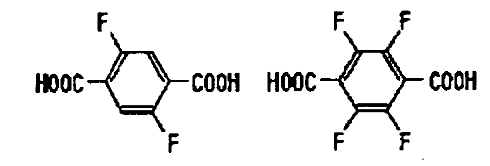

Further, for example, diphenyl ether-4,4'-dicarboxylic acid, diphenyl ether-3,3'-dicarboxylic acid, diphenyl ether-3,4'-dicarboxylic acid, benzophenone-4,4'- dicarboxylic acid, benzophenone-3,4'-dicarboxylic acid, diphenylsulfone-4,4'-dicarboxylic acid, diphenylsulfone-3,4'-dicarboxylic acid, and the following ones are exemplified.

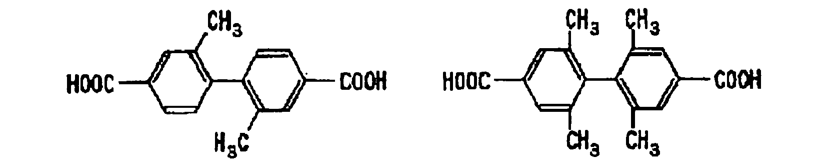

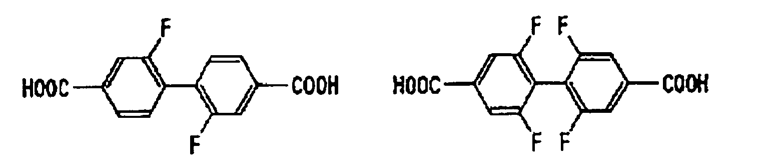

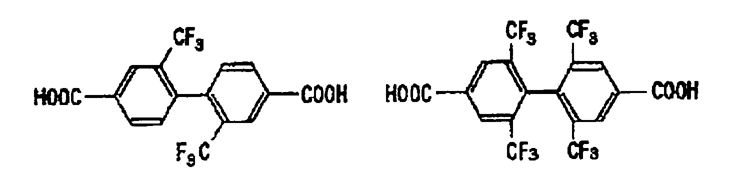

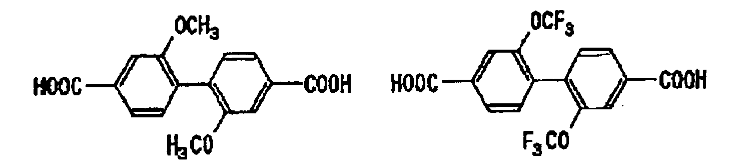

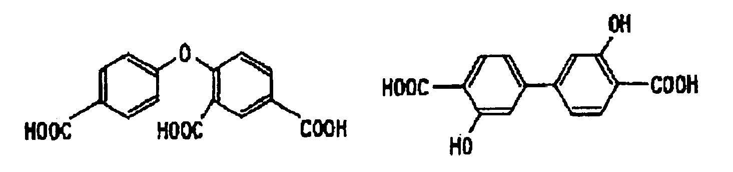

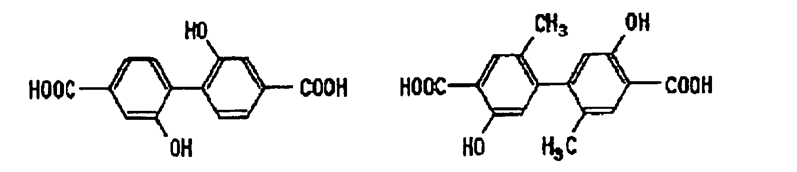

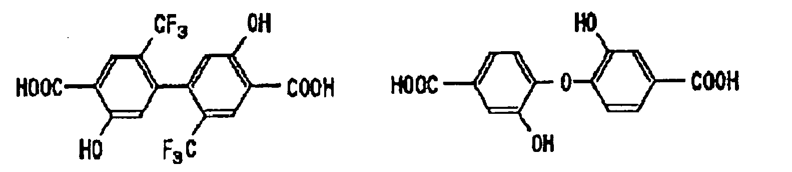

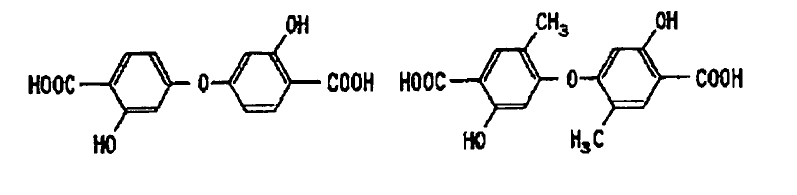

As the organic solvents for use in the above reaction, polar solvents capable of completely dissolving the PBO precursor formed are preferably used, and, e.g., N-methyl-2- pyrrolidone, N,N-dimethylacetamide, N,N-dimethylformamide, dimethyl sulfoxide, and γ-butyrolactone are exemplified.

The PBO precursor can be obtained, for example, by the reaction of dicarboxylic acid dihalide (chloride, bromide, etc.) and diamine. In this case, it is preferred to perform the reaction in an organic solvent in the presence of a dehalogenating acid catalyst. As the dicarboxylic acid dihalide, dicarboxylic acid dichloride is preferred. The dicarboxylic acid dichloride can be obtained by the reaction of dicarboxylic acid and thionyl chloride.

The molecular weight of the PBO precursors is not especially restricted, and is preferably from 5,000 to 100,000 as weight average molecular weight. The molecular weight can be measured according to gel permeation chromatography and conversion to standard polystyrene.

### (A4) Polyamide resin containing an acid-decomposable group:

As polyamide resin containing an acid-decomposable group, for example, resin having a structure represented by the following formula (A4) can be exemplified.

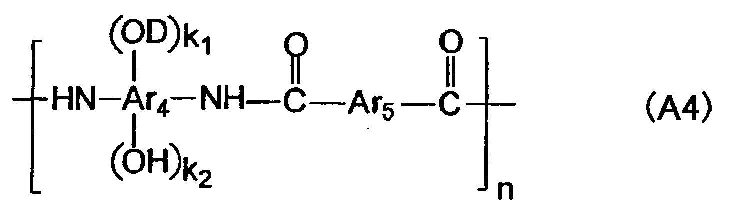

In formula (A4), k₁ represents an integer of 1 or 2; k₂ represents an integer of 0 or 1, and the sum of k₁ and k₂ is 2; Ar₄ represents a tetravalent aromatic group, aliphatic group or heterocyclic group, or mixture of these groups; Ar₅ represents a divalent aromatic group, aliphatic group or heterocyclic group, or a siloxane group; D represents an acid-decomposable group (a monovalent group labile to acid); and n represents an integer of from 20 to 200.

Ar₄ represents a tetravalent aromatic group, aliphatic group or heterocyclic group, or mixture of these groups, which contains the following structures: 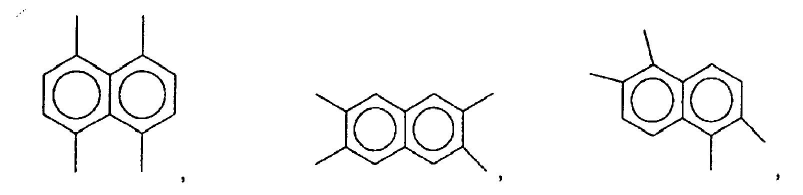 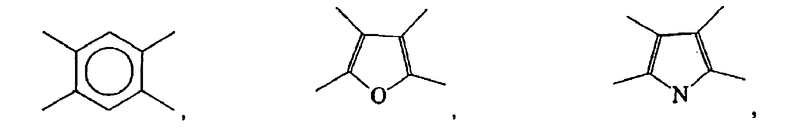 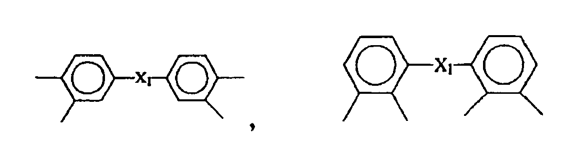 (wherein X₁ represents -O-, -S-, -C(CF₃)₂-, -C(CH₃)₂-, -CH₂-, -SO₂-, -NHCO-, -C(=O)-, -C(=O)-C(=O)-, -C(=O)-O-), and further a part having the following group is also contained, but the invention is not restricted thereto.

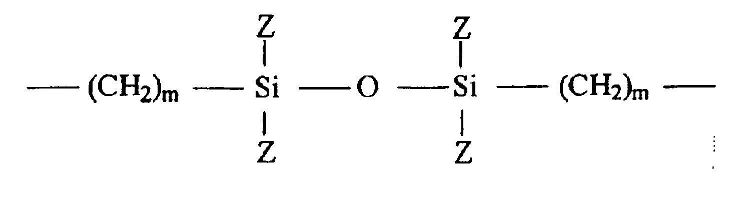

In the above formula, each Z represents a hydrogen atom or an alkyl group; and each m represents an integer of from 1 to 6.

In addition, a part of Ar₄ may be a diamine part of a divalent aromatic group, aliphatic group or heterocyclic group, so that the proportion of the diamine compound is from 0 to 60 mol%, and the total of the diamine and diaminodihydroxy compound is 100%.

Ar₅ represents a divalent aromatic group, aliphatic group, heterocyclic group, or siloxane group, or mixture of these groups, which contains any of the following structures: 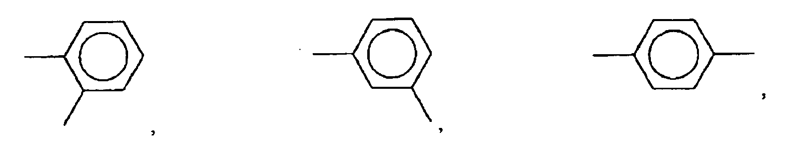 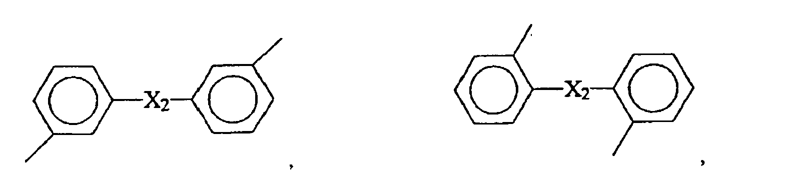 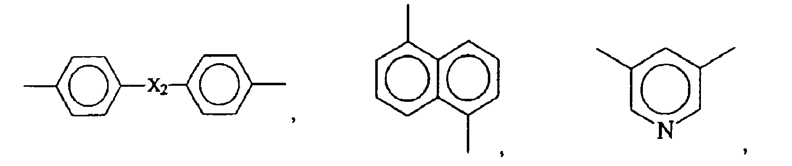 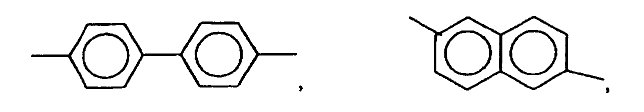 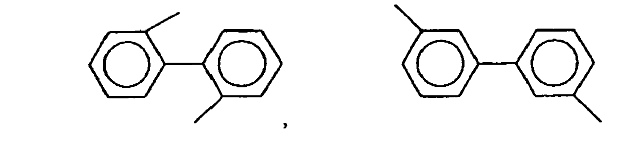 and -C(=O) -C(=O)-, -C(=O)-O-, and a part having a group represented by the following formula (where Z represents a hydrogen atom or an alkyl group, and p represents an integer of from 1 to 6), 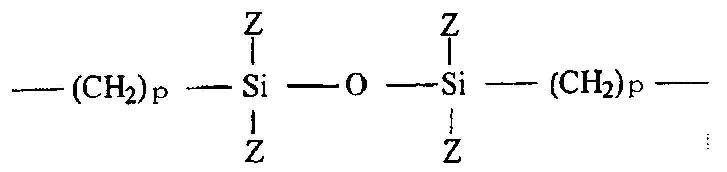 (wherein X₂ represents -O-, -S-, -C(CF₃)₂-, -C(CH₃)₂-, -CH₂-, -SO₂-, -NHCO- or -C(=O)-), but the invention is not restricted thereto. The polymer may contain one or more different Ar₄ and Ar₅ groups.

D is a preferred arbitrary monovalent acid-decomposable group labile to acid, such as a part containing acetal, ketal, carbonate, ether, silyl ether, t-butyl ester, or mixture of these parts, for example, the following structures can be exemplified, but the invention is not restricted thereto.

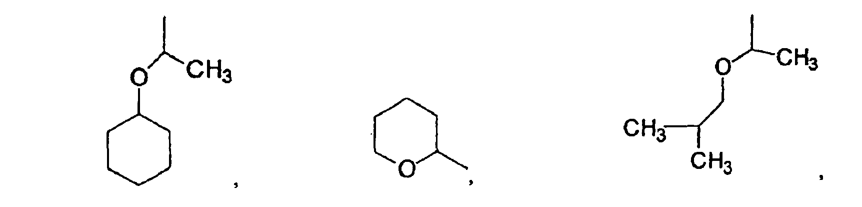

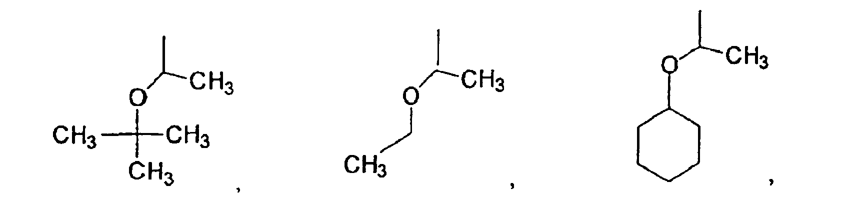

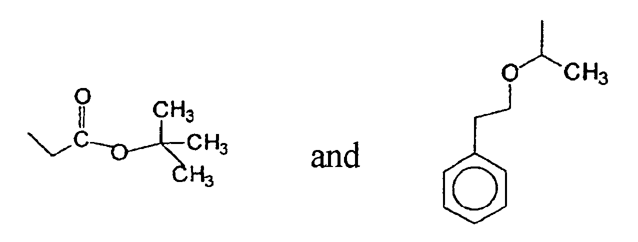

### [3] Photosensitizer

Photosensitizers contained in a photosensitive resin composition as the photosensitive components are not especially restricted but a quinonediazide photosensitizer and a photo-acid generator are preferably used.

Quinonediazide photosensitizers are not especially restricted and known quinonediazide photosensitizers can be used, and a naphthoquinonediazide photosensitizer is preferably used.

o-Quinonediazide photosensitizers can be obtained, e.g., by the condensation reaction of o-quinonediazide sulfonyl chlorides with a hydroxyl compound or an amino compound in the presence of a dehydrochlorinating agent.

As the o-quinonediazide sulfonyl chlorides, e.g., benzoquinone-1,2-diazide-4-sulfonyl chloride, naphthoquinone-1,2-diazide-5-sulfonyl chloride, and naphthoquinone-1,2-diazide-4-sulfonyl chloride can be used.

As the hydroxyl compounds, e.g., hydroquinone, resorcinol, pyrogallol, bisphenol A, bis(4-hydroxyphenyl)- methane, 2,2-bis(4-hydroxyphenyl)hexafluoropropane, 2,3,4-trihydroxybenzophenone, 2,3,4,4'-tetrahydroxybenzophenone, 2,2',4,4'-tetrahydroxybenzophenone, 2,3,4,2',3'-pentahydroxybenzophenone, 2,3,4,3',4',5'-hexahydroxybenzophenone, bis(2,3,4-trihydroxyphenyl)methane, bis(2,3,4-trihydroxyphenyl)propane, 4b,5,9b,10-tetrahydro-1,3,6,8-tetrahydroxy-5,10-dimethylindeno[2,1-a]indene, tris(4-hydroxyphenyl)-methane, tris(4-hydroxyphenyl)ethane and the like can be used.

As the amino compounds, e.g., p-phenylenediamine, m-phenylenediamine, 4,4'-diaminodiphenyl ether, 4,4'-diaminodiphenylmethane, 4,4'-diaminodiphenylsulfone, 4,4'-diaminodiphenyl sulfide, o-aminophenol, m-aminophenol, p-aminophenol, 3,3'-diamino-4,4'-dihydroxybiphenyl, 4,4'-diamino-3,3'-dihydroxybiphenyl, bis(3-amino-4-hydroxyphenyl)propane, bis(4-amino-3-hydroxyphenyl)propane, bis(3-amino-4-hydroxyphenyl)sulfone, bis(4-amino-3-hydroxyphenyl)sulfone, bis(3-amino-4-hydroxyphenyl)hexafluoropropane, bis(4-amino-3-hydroxyphenyl)hexafluoropropane and the like can be used.

It is preferred that the o-quinonediazide sulfonyl chloride and the hydroxyl compound and/or amino compound are blended so that the sum total of the hydroxyl group and the amino group is from 0.5 to 1 equivalent to 1 mol of the o-quinone- diazide sulfonyl chloride. The preferred range of proportion of the dehydrochlorinating agent and the o-quinonediazide sulfonyl chloride is from 0.95/1 to 1/0.95. The preferred reaction temperature is from 0 to 40°C, and the preferred reaction time is from 1 to 10 hours.

As the reaction solvents, dioxane, acetone, methyl ethyl ketone, tetrahydrofuran, diethyl ether, N-methylpyrrolidone, etc., are used. As the dehydrochlorinating agent, sodium carbonate, sodium hydroxide, sodium hydrogencarbonate, potassium carbonate, potassium hydroxide, trimethylamine, triethylamine, pyridine, etc., are exemplified.

In the positive photosensitive resin composition in the invention, the blending amount of the quinonediazide photosensitizer is, from the points of the difference in dissolution rate between an unexposed area and an exposed area, and the tolerance of sensitivity, preferably from 5 to 100 mass parts per 100 mass parts of the PBO precursor, and more preferably from 8 to 40 mass parts.

As the quinonediazide photosensitizers, e.g., compounds having any of the following structures can be exemplified. 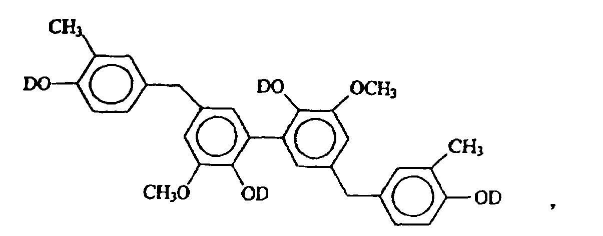 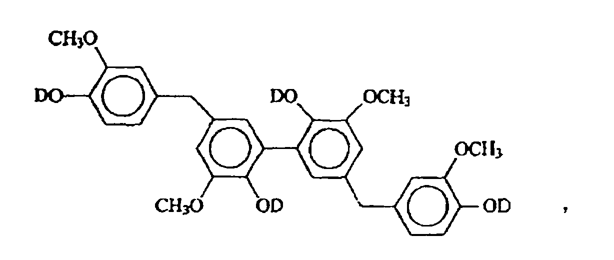 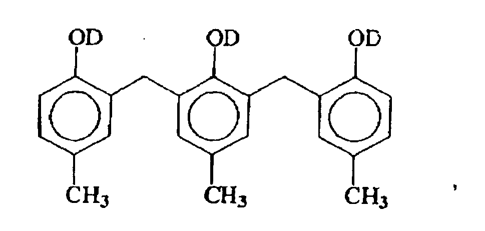 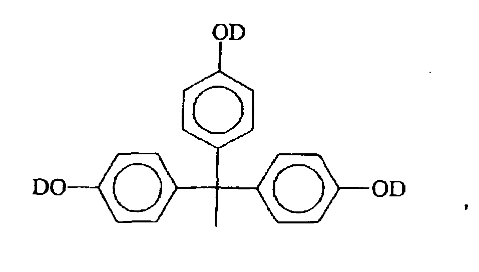 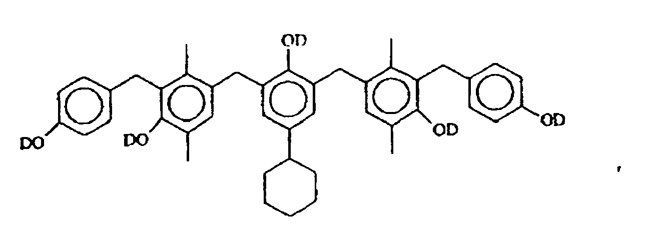 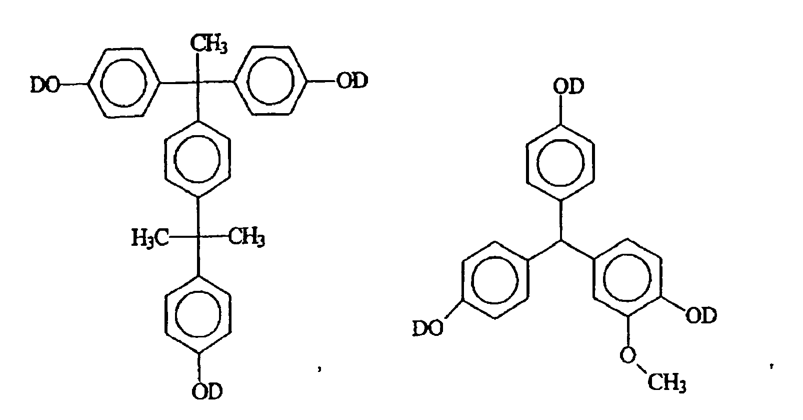 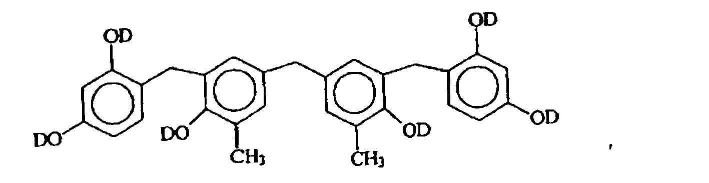 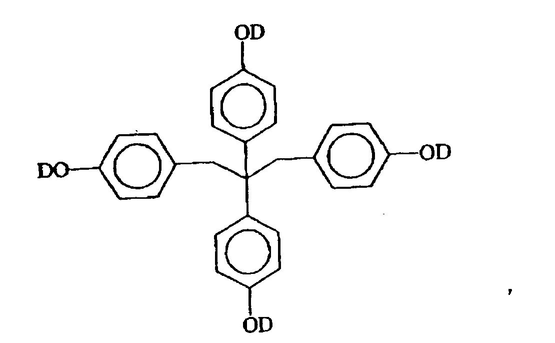 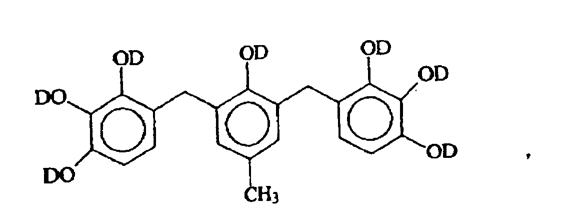 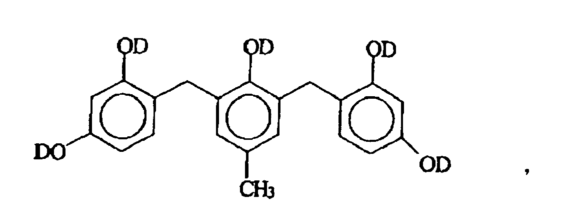 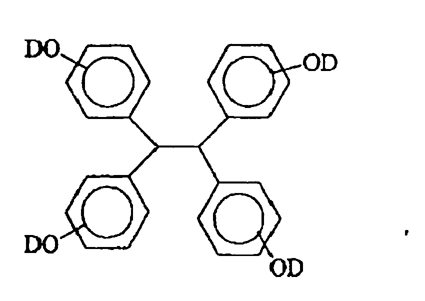 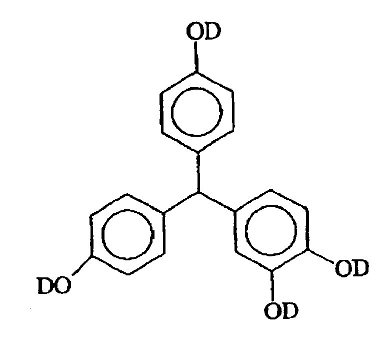 and

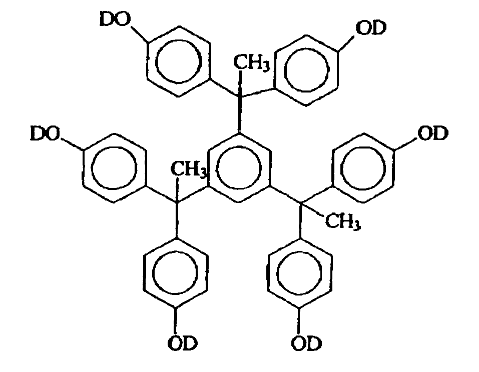

In the formulae, D represents H or any of the following groups.

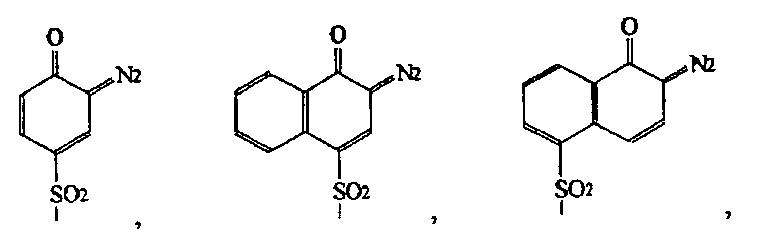

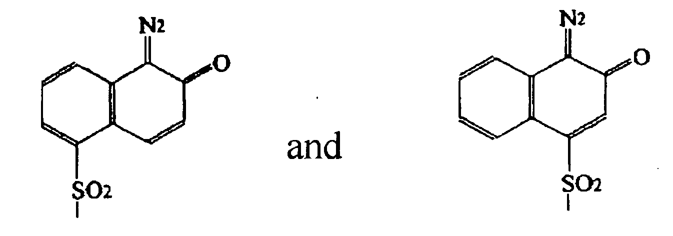

However, it is sufficient that at least one of D's in each compound is a quinonediazide group.

Commercially available quinonediazide photosensitizers may be used, or quinonediazide photosensitizers may be synthesized according to known methods.

As photo-acid generators, e.g., a triazine compound, sulfonate, disulfone, an onium salt, and mixtures of these compounds are known. The most preferred photo-acid generators are onium salts such as iodonium, sulfonium, phosphonium, diazonium, sulfoxonium and mixtures of these compounds. As also preferred photo-acid generators, those that can be used in g-line, i-line, 248 nm and broadband lithography are known.

For heightening absorption to actinic radiation wavelength, a photo-intensifier or a dye can be added to a photosensitive resin composition. As the photo-intensifiers, e.g., a fluorenone derivative, naphthalene, an anthracene derivative, coumarin, a pyrene derivative, benzyl, a fluorescein derivative, benzophenone, benzanthrone, xanthone, phenothiazine, and mixtures of these compounds are exemplified.

### [4] Solvent

The photosensitive resin composition in the invention is prepared as a preferred coating solution containing at least a photosensitizer and resin dissolved in a solvent.

The examples of solvents include N-methylpyrrolidone (NMP), γ-butyrolactone (GBL), N,N-dimethylacetamide (DMAc), dimethyl-2-piperidone, N,N-dimethylformamide (DMF), dimethyl sulfoxide, 2-methoxyethanol, diethylene glycol diethyl ether, diethylene glycol dibutyl ether, dipropylene glycol monomethyl ether, propylene glycol monomethyl ether acetate, methyl-1, 3-butylene glycol acetate, 1, 3-butylene glycol acetate, cyclohexanone, cyclopentanone, tetrahydrofuran, ethyl lactate, propylene glycol monomethyl ether, and propylene carbonate, but the invention is not restricted thereto.

As preferred solvents, organic solvents such as N-methylpyrrolidone (NMP), γ-butyrolactone (GBL), N,N-dimethylacetamide (DMAc), dimethyl-2-piperidone, N,N-dimethylformamide (DMF), ethyl lactate, propylene glycol monomethyl ether acetate, propylene glycol monomethyl ether, propylene carbonate, and mixtures of these solvents are exemplified, but the invention is not restricted thereto. More preferred solvents are γ-butyrolactone and N-methylpyrrolidone, and γ-butyrolactone is most preferred.

The concentration of all the solids content of the photosensitive resin composition (corresponding to all the solids content forming a film after drying) of the invention is from 30 mass% or more, and preferably from 30 to 50 mass%.

After filtration, a solvent may be added to make the concentration generally from 15 to 50 mass%, preferably from 25 to 45 mass%, and may be used for coating.

### [5] Adhesion accelerator

The photosensitive resin composition in the invention may contain an adhesion accelerator. As preferred adhesion accelerators, e.g., dianhydride/DAPI/bis(3-aminopropyl)-tetramethylsiloxane (BATS) polyamidic acid copolymer, aminosilane, and mixtures of these compounds are exemplified. By the addition of dianhydride/DAPI/BATS polyamidic acid copolymer, adhesion characteristics are increased.

Dianhydride/DAPI/BATS polyamidic acid copolymer can be synthesized by the reaction of tetracarboxylic dianhydride (J), BATS diamine and DAPI diamine in a reaction solvent according to the following reaction scheme.

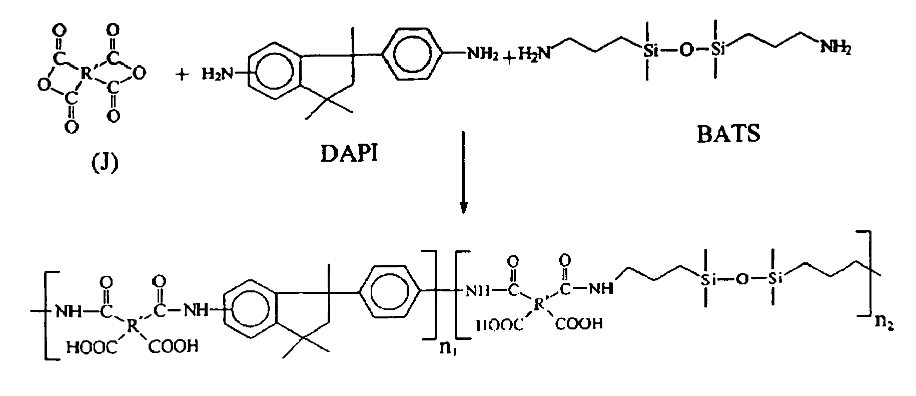

In the above formula, R' represents a tetravalent group.

Tetracarboxylic dianhydride (J) may be pyromellitic dianhydride (PMDA), 3,3',4,4'-benzophenonetetracarboxylic dianhydride, 3,3',4,4'-biphenyltetracarboxylic dianhydride, 3,3',4,4'-diphenylsulfonetetracarboxylic dianhydride, 4,4'-perfluoroisopropylidynediphthalic dianhydride, 4,4'-oxydiphthalic dianhydride, bis(3,4-dicarboxyl)-tetramethyldisiloxane dianhydride, bis(3,4-dicarboxyphenyl)dimethylsilane dianhydride, butanetetracarboxylic dianhydride, 1,4,5,8-naphthalenetetracarboxylic dianhydride, and mixtures of these compounds, but the invention is not restricted thereto.

The molar ratio of DAPI/BATS is about 0.1/99.9 to 99.9/0.1, preferably about 10/90 to 40/60, and most preferably about 15/85 to 30/70.

The preferred reaction solvents are N-methyl-2-pyrrolidinone (NMP), γ-butyrolactone (GBL), N,N-dimethylformamide (DMF), N,N-dimethylacetamide (DMAc), dimethyl sulfoxide (DMSO), sulforan, and diglyme. The most preferred reaction solvents are N-methyl-2-pyrrolidinone (NMP) and γ-butyrolactone (GBL).

For the reaction of dianhydride with the above-described two diamines, preferred arbitrary reaction may be used. In general, the reaction temperature is from about 10 to about 50°C and the reaction time is about 6 to 48 hours. The molar ratio of dianhydride to diamines should be about 0.9 to 1.1/1.

The photosensitive resin composition in the invention can further contain other additives, e.g., a flattening agent, etc.

If necessary, an adhesion improver, e.g., an organic silicon compound, a silane coupling agent, or a leveling agent may be added to the positive photosensitive resin composition in the invention for providing an adhering property. As the examples of adhesion improvers, γ-aminopropyltrimethoxy- silane, γ-aminopropyltriethoxysilane, vinyltriethoxysilane, γ-glycidoxypropyltriethoxysilane, γ-methacryloxypropyltrimethoxysilane, urea propyltriethoxysilane, tris(acetyl-acetonato) aluminum, acetylacetatoaluminum diisopropylate, etc., are exemplified. When an adhesion improver is used, the addition amount is preferably from 0.1 to 20 mass parts per 100 mass parts of the PBO precursor, and more preferably from 0.5 to 10 mass parts.

### [6] Pattern-Forming Method

A method for forming a relief pattern (a relief image) with the photosensitive resin composition of the invention comprises applying the photosensitive resin composition after filtration on an appropriate substrate (a coating process), baking the film coated on the substrate (a heat treatment process), exposing with actinic ray or radiation (an exposure process), and developing with a developing solution (a development process), whereby a relief pattern can be formed.

It is preferred to perform heat treatment after the exposure process, and it is also preferred to perform heat treatment (e. g. , from 200 to 400°C) after the development process. Further, a developed substrate may be rinsed before heat treatment.

Thus, a semiconductor device can be manufactured with the photosensitive resin composition of the invention by coating the composition on a substrate element, prebaking, exposing, developing, and heat curing, so as to reach a prescribed thickness after heat curing (e.g., from 0.1 to 30 µm).

A method for forming a relief pattern is described in detail below.

The photosensitive resin composition of the invention is coated on a preferred substrate. The substrate is, e.g., semiconductor materials such as a silicon wafer, a ceramic substrate, glass, metal, or plastics. The coating methods include spray coating, rotary coating, offset printing, roller coating, screen printing, extrusion coating, meniscus coating, curtain coating, and immersion coating, but the invention is not restricted thereto.

For evaporating the remaining solvent, the coated film is previously subjected to baking at high temperature of about 70 to 120°C for several minutes to half an hour, according to the method. In the next place, the obtained dried film is subjected to exposure through a mask of a preferred pattern with actinic ray or radiation. As the actinic ray or radiation, X-ray, electron beam, UV-ray, and visible ray can be used. The most preferred radiations are the radiations having wavelength of 436 nm (g-line) and 365 nm (i-line).

It is advantageous to heat the coated and exposed substrate at about 70 to 120°C subsequent to exposure with actinic ray or radiation. The coated and exposed substrate is heated for a short period of time, generally from several seconds to several minutes within the range of the temperature. This step of the method is in general technically called post-exposure baking.

In the next place, the coated film is developed with an aqueous developer to thereby form a relief pattern. As the aqueous developers, alkali solutions, e.g., inorganic alkali (e.g., potassium hydroxide, sodium hydroxide, aqueous ammonia), primary amine (e.g., ethylamine, n-propylamine), secondary amine (e.g., diethylamine, di-n-propylamine), tertiary amine (e.g., triethylamine), alcohol amine (e.g., triethanolamine), quaternary ammonium salt (e.g., tetramethylammonium hydroxide, tetraethylamonium hydroxide), and mixtures of these compounds are exemplified. The most preferred developers are those containing tetramethylammonium hydroxide. In addition, a proper amount of a surfactant may be added to the developer. For the development, immersion, spraying, paddling, or other similar development methods can be used.

According to circumstances, the relief pattern is then rinsed with deionized water. Subsequently, the relief pattern is cured for obtaining a final pattern of highly heat resisting polymer, whereby an oxazole ring is formed. Curing is carried out by baking the substrate at the glass transition temperature Tg of the polymer so as to obtain an oxazole ring forming a highly heat resisting final pattern. In general, temperature of higher than about 200°C is used, and preferably from about 250 to 400°C is used.

### EXAMPLE

The invention will be described in detail with reference to examples, but the invention is not limited thereto.

### Synthesis of photosensitizer:

### (1) Synthesis example of quinonediazide sulfonnate

### Synthesis of quinonediazide sulfonnate (B1) of phenol compound (B1) :

Into a three neck flask were put 18.9 g of phenol compound (b1) and 200 ml of 1,4-dioxane, and dissolved until the content became homogeneous. 1,2-Naphthoquinone-diazide-4-sulfonyl chloride (13.4 g) was then added to the solution and dissolved. The reaction vessel was cooled to 10°C with ice water, and 5.6 g of triethylamine was dropped to the solution over 1 hour. After termination of dropping, the reaction solution was stirred for 12 hours. In the next place, 13.4 g of 1,2-naphthoquinonediazide-5-sulfonyl chloride was added and dissolved. The reaction vessel was cooled to 10°C with ice water, and 5. 6 g of triethylamine was dropped to the solution over 1 hour. After termination of dropping, the reaction solution was stirred for 4 hours. After termination of the reaction, distilled water was added and the precipitated salt was dissolved, and the solution was stirred for 30 minutes. After neutralizing with dilute hydrochloric acid, the solution was crystallized in 1 liter of distilled water. The dark yellow powder precipitated was recovered by filtration. The recovered product was dissolved in 200 ml of dioxane again and crystallized in 1 liter of distilled water. The precipitated product was filtered, and the recovered product was washed with 1 liter of distilled water, and filtered to recover 33.2 g of objective product (B1) as dark yellow powder. As a result of the analysis of the obtained (B1) by high performance liquid chromatography (S1525, manufactured by Waters Corporation), the purity of esterified product of phenol compound (b1) was confirmed to be 96% (detection wavelength: 254 nm).

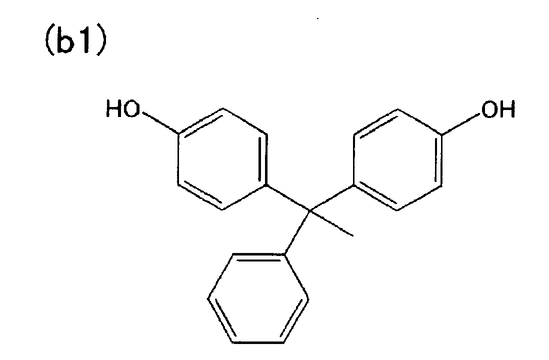

### Synthesis of PBO precursor resin:

### (2) Synthesis of resin A-1:

Into a three neck flask having a capacity of 100 ml were put 3.85 g (10.5 mmol) of hexafluoro-2,2-bis(3-amino-4-hydroxyphenyl) propane, 1.70 g (21 mmol) of pyridine, and 15 g of N-methyl-2-pyrrolidone (NMP). The solution was stirred at room temperature until all the solids were dissolved, and then the solution was cooled in an ice bath at 0 to 5°C. To the solution was dropped 1.48 g (5 mmol) of 1,4-oxydibenzoyl chloride having been dissolved in 1.02 g (5 mmol) of isophthaloyl chloride and 10 g of NMP. After termination of dropping, the obtained mixture was stirred at room temperature for 18 hours. The dense solution was thrown into 800 ml of vigorously stirred deionized water, and the precipitated white powder was recovered by filtration. The recovered reaction product was washed with a mixture of deionized water and water/methanol (50/50). The obtained polymer was dried at 40°C for 24 hours in vacuo to obtain objective resin A-1. The yield was almost theoretical amount. The intrinsic viscosity of resin A-1 measured at 25°C in NMP in the concentration of 0.5 g/dL was 0.28 dL/g.

### (3) Synthesis of resin A-2:

The polymer of the above resin A-1 (5.42 g) (10.0 mmol) and 50 ml of tetrahydrofuran (THF) were put in a reaction vessel. The mixture was stirred for 10 minutes to completely dissolve the solids. In the next place, 0.54 g (2 mmol) of 1,2-naphthoquinonediazide-5-sulfonyl chloride was added and the mixture was stirred for further 10 minutes. Triethylamine (0.20 g) (2 mmol) was slowly added over 30 minutes, and then the reaction mixture was stirred for 5 hours. Subsequently, the reaction mixture was gradually added to 500 ml of vigorously stirred deionized water. The precipitated product was separated by filtration, and washed with 200 ml of deionized water. To the product was further added 600 ml of deionized water, and the mixture was vigorously stirred for 30 minutes. After filtration, the product was washed with 100 ml of deionized water. The isolated product was dried at 40°C overnight. The yield was 90%.

### (4) Preparation and evaluation of photosensitive resin composition:

Resin A-1, photosensitizer B1 of 13 mass% to the resin, and adhesion accelerator C (an alkoxysilane compound) shown below of 2 mass% to the resin were dissolved in γ-butyrolactone, and 200 g of a solution having the concentration of solids content of 40 mass% was prepared. Each 100 g of the solution was taken out, and the filtration amount and filtration time were measured at the time of filtering by the pressure of 0.4 MPa with a hollow fiber filter (a filter having a pore size of 0.1 µm manufactured by KITZ MICROFILTER CORPORATION) and a cassette type tetrafluoroethylene filter (having a pore size of 0.2 µm manufactured by Advantec Toyo Kaisha, Ltd.) (in Fig. 1, A is a cassette type membrane filter and B is a hollow fiber filter). The hollow fiber filter could filter a greater amount of solution in a shorter time, although the filter size is smaller. To measure the viscosity, the solution having the concentration of solids content of 30 mass% was prepared by dilution with γ-butyrolactone, then the viscosity was measured at 23°C using viscometer TV-22 manufactured by Toki Sangyo Co., Ltd., and found to be 1.4 Pa·s.

Each filtered solution was coated on a wafer and the surface coating defect of the wafer was evaluated with a defect tester (KLA 2360). The number of defects of the solution filtered through the hollow fiber filter was 1/10 or less as compared with the solution filtered through the cassette type tetrafluoroethylene filter.

### (5) Resin A-2 was dissolved in γ-butyrolactone and a solution having the concentration of solids content of 40 mass% was prepared (resin solution 1). Resin solution 1 was filtered through a cassette type tetrafluoroethylene filter (having a pore size of 0.2 µm manufactured by Advantec Toyo Kaisha, Ltd.) (resin solution 2).

Resin solution 2, photosensitizer B1 (13 mass% to the resin), and adhesion accelerator C (an alkoxysilane compound) shown below of 2 mass% to the resin were mixed, and a photosensitive resin composition (composition 1) was prepared by adding γ-butyrolactone so that the concentration of solids content became 40 mass%. A photosensitive resin composition (composition 2) was manufactured in the same manner as in the manufacture of composition 1 except for using resin solution 1. The filtration amount and filtration time of composition 1 and composition 2 were measured at the time of filtering by the pressure of 0.4 MPa with a hollow fiber filter (a filter having a pore size of 0.1 µm manufactured by KITZ MICROFILTER CORPORATION).

Composition 1 could be filtered in a greater amount in a shorter time than composition 2. To measure the viscosity, the solution having the concentration of solids content of 25 mass% was prepared by diluting Composition 1 with γ-butyrolactone, then the viscosity was measured at 23°C using viscometer TV-22 manufactured by Toki Sangyo Co., Ltd., and found to be 650 mPa·s. Also, the solution having the concentration of solids content of 30 mass% was prepared by diluting Composition 2 with γ-butyrolactone, then the viscosity was measured in the same way, and found to be 1.5 Pa·s.

Each filtered solution was coated on a wafer and the surface coating defect of the wafer was evaluated with a defect tester (KLA 2360). The number of defects of composition 1 was 1/50 or less as compared with composition 2.

The filtration was performed at 23°C.

### Adhesion Accelerator C

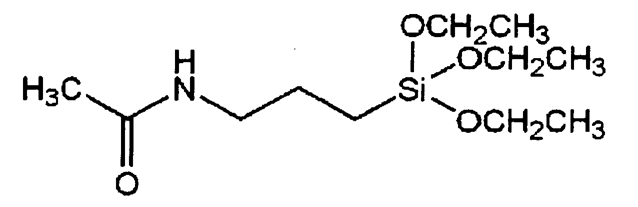

A relief structure little in coating defects, excellent in heat resistance, mechanical characteristics, electrical characteristics and chemical resistance can be manufactured with the photosensitive resin composition manufactured by the manufacturing method of the composition of the invention, and the photosensitive resin composition can be preferably used for semiconductor use and as a buffer coat.

The entire disclosure of each and every foreign patent application from which the benefit of foreign priority has been claimed in the present application is incorporated herein by reference, as if fully set forth.

## Claims

1. A method for manufacturing a positive photosensitive resin composition, the method comprising:
filtering a composition having a concentration of solids content of 30 mass% or more through a hollow fiber filter having a pore size of 0.1 µm or less, wherein the composition comprises: (A) resin; (B) a photosensitizer; and (C) a solvent.

2. The method according to claim 1,
wherein the resin (A) is a resin containing at least one structure selected from the group consisting of a polyimide structure, a polyimide precursor structure, a polybenzoxazole structure and a polybenzoxazole precursor structure.

3. The method according to claim 1, which further comprises:
filtering a resin solution comprising a solvent in which the resin (A) is dissolved through a filter having a pore size of 0.2 µm or less before filtering the composition.

4. The method according to claim 1,
wherein the resin (A) is a polyamide resin containing a naphthoquinonediazide group.

5. The method according to claim 1,
wherein the resin (A) is a polyamide resin containing an acid decomposable group.

6. The method according to claim 1,
wherein the photosensitizer (B) is selected from the group consisting of a naphthoquinonediazide photosensitizer and a photo-acid generator.

7. A relief pattern obtained by a process comprising:
applying a photosensitive resin composition manufactured by a method according to claim 1 on a substrate, so as to form a film;
baking the film, so as to form a dried film;
exposing the dried film with actinic ray or radiation, so as to form an exposed film; and
developing the exposed film with a developing solution, so as to form a relief pattern.

8. The relief pattern according to claim 7,
wherein the process further comprises:
heating the exposed film before developing the exposed film.

9. The relief pattern according to claim 7, which is subjected to a heat processing at 200 to 400°C.

10. The method according to claim 1,
wherein a material of the hollow fiber filter is at least one selected from the group consisting of polyacrylonitrile, polypropylene, polyethylene, nylon, plyester, polycarbonate, polyvinylidene fluoride and ethylene-tetrafluoroethylene.
